# EUROPEAN PATENT APPLICATION

(11) **EP 4 514 105 A1**
(43) Date of publication of application: **26.02.2025**
(21) Application number: 24189859.2
(22) Date of filing: 19.07.2024
(51) Int. Cl.: H10K 59/122, H10K 59/35, H10K 59/38, H10K 59/80

(54) **LIGHT EMITTING DISPLAY DEVICE INCLUDING SHAPED LIGHT EMITTING AREAS**

(30) Priority: 23.08.2023 KR 20230110506; 05.12.2023 KR 20230174666
(71) Applicant: Samsung Display Co., Ltd., Gyeonggi-do 17113 (KR)
(72) Inventor: CHOI, Kook Hyun, Yongin-si (KR); KIM, Changwook, Yongin-si (KR); BACK, Changhyun, Yongin-si (KR); ANN, Minjung, Yongin-si (KR); LEE, Wang Jo, Yongin-si (KR); LEE, Jun Hee, Yongin-si (KR); CHO, Hyun Duck, Yongin-si (KR); CHOI, Beohm Rock, Yongin-si (KR); CHOI, Yechan, Yongin-si (KR)
(74) Representative: Marks & Clerk LLP

(57) **Abstract**

A light emitting display device includes a substrate, anodes disposed on the substrate, a pixel defining layer having first openings overlapping each of the anodes, light emitting layers each disposed within the first openings of the pixel defining layer, a cathode disposed on the light emitting layers and the pixel defining layer, an encapsulation layer disposed on the cathode, and a light blocking layer disposed on the encapsulation layer and including second openings each overlapping the first openings. One unit pixel includes two light emitting areas of a first color, one light emitting area of a second color, and one light emitting area of a third color. The light emitting areas of the first color have a diamond shape, the second color and the third color light emitting areas each have a rectangular shape, and at least one second opening has an oval shape.

## Description

### TECHNICAL FIELD

The present disclosure relates to a light emitting display device and, more specifically, to a light emitting display device including shaped light emitting areas.

### DISCUSSION OF THE RELATED ART

A display device is a device that displays an image on a screen. Examples of display devices commonly in use today include a liquid crystal display (LCD) and an organic light emitting diode (OLED) display.

These display devices are used in various electronic devices such as mobile phones, navigation devices, digital cameras, electronic book readers, portable game consoles, and various computerized terminals.

A display device, such as an organic light emitting display device, may have a structure that can be bent or folded to a noticeable extent without cracking or otherwise sustaining damage. These so-called bendable display devices may include a flexible substrate.

In addition, in small electronic devices such as mobile phones, optical elements such as cameras and optical sensors may be disposed in the bezel area around the display area. However, as the size of the display screen increases and the size of the area surrounding the display area gradually decreases, technology is being developed that allows optical elements to be positioned on the back of the display area, e.g., behind the display area, rather than in the bezel.

### SUMMARY

A light emitting display device includes a substrate, a plurality of anodes disposed on the substrate, a pixel defining layer having a plurality of first openings overlapping each of the plurality of anodes, a plurality of light emitting layers, each disposed within the plurality of first openings of the pixel defining layer, a cathode disposed on the plurality of light emitting layers and the pixel defining layer, an encapsulation layer disposed on the cathode, and a light blocking layer disposed on the encapsulation layer and including a plurality of second openings each overlapping the plurality of first openings. One unit pixel includes four light emitting areas, and the four light emitting areas include two light emitting areas of a first color, one light emitting area of a second color, and one light emitting area of a third color. The light emitting areas of the first color have a diamond shape. The light emitting areas of the second color and the third color each have a rectangular shape, and at least one first opening, among the plurality of first openings of the pixel defining layer, or at least one second opening, among the plurality of second openings of the light blocking layer, has an oval shape.

The oval shape may include four or more major axis angles, and the angle formed by the major axis direction of the oval shape may be 45 degrees or less.

The oval shape may have an eccentricity within a range of 0.2 to 0.85.

The first opening and the second opening that overlaps the first opening may have a horizontal gap within a range of more than 0 µm to 20 µm.

The oval shape may have a planar shape that merges at least two oval shapes with different plane eccentricities.

The elliptical shape may have a planar shape formed by cutting a first ellipse with a first eccentricity and a second ellipse with a second eccentricity in a first direction and then combining them.

Both the first opening of the pixel defining layer and the second opening of the light blocking layer may have an oval shape.

One of the first opening of the pixel defining layer and the second opening of the light blocking layer may have a circular shape, and the other may have an oval shape.

The first opening may have a circular shape, the second opening may have an oval shape, and the first opening and the second opening may contact each other in a plan view.

The light emitting display device may further include a plurality of color filters that fill each of the plurality of second openings.

A light emitting display device includes a substrate, a plurality of anodes disposed on the substrate, a pixel defining layer having a plurality of first openings overlapping with each of the plurality of anodes, a plurality of light emitting layers each disposed within the plurality of first openings of the pixel defining layer, a cathode disposed on the plurality of light emitting layers and the pixel defining layer, a sealing layer (e.g. encapsulation layer) disposed on the cathode, and a plurality of color filters corresponding to different colors disposed on the sealing layer. Two or more color filters, of the plurality of color filters, overlap in the light blocking area of the color filter, and include a plurality of second openings where only one color filter of the plurality of color filters is disposed. One unit pixel includes four light emitting areas. The four light emitting areas include two light emitting areas of a first color, and one each of the remaining second and third color light emitting areas, and the light emitting areas of the first color, have a diamond shape. The light emitting areas of the second and third colors each have a rectangular shape. At least one of the first openings of the plurality of first openings of the pixel defining layer or at least one of the second openings of the plurality of second openings of the color filter has an elliptical shape.

The oval shape may include four or more major axis angles, and the angle formed by the major axis direction of the oval shape may be 45 degrees or less.

The oval shape may have an eccentricity within a range of 0.2 to 0.85.

The first opening and the second opening that overlaps the first opening may have a horizontal gap within a range of more than 0 µm to 20 µm.

The oval shape may have a planar shape that merges at least two oval shapes with different plane eccentricities.

The elliptical shape may have a planar shape formed by cutting a first ellipse with a first eccentricity and a second ellipse with a second eccentricity in a first direction and then combining them.

The light blocking area of the color filter may overlap a blue color filter and a red color filter, and each of the plurality of second openings may overlap one of the blue color filter, the red color filter, and the green color filter.

Both the first opening of the pixel defining layer and the second opening of the color filter may have the oval shape.

One of the first opening of the pixel defining layer and the second opening of the color filter may have a circular shape, and the other may have the oval shape.

The first opening may have the circular shape, the second opening may have the oval shape, and the first opening and the second opening may contact each other in a plan view.

At least some of the above and other features of the invention are set out in the claims.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
FIG. 1 is a schematic perspective view illustrating a use state of a display device according to an embodiment.
FIG. 2 is an exploded perspective view of a display device according to an embodiment.
FIG. 3 is a block diagram of a display device according to an embodiment.
FIG. 4 is a perspective view schematically showing a light emitting display device according to an embodiment.
FIG. 5 is an enlarged plan view of a partial area of a light emitting display device according to an embodiment.
FIG. 6 is a schematic cross-sectional view of a display panel according to an embodiment.
FIG. 7 to FIG. 9 are plan views of a portion of a display panel according to an embodiment.
FIG. 10 is a plan view of a portion of a display panel according to a comparative example.
FIG. 11 is a photograph of the reflection characteristics of the comparative example and the examples of FIG. 7 to FIG. 9.
FIG. 12 is a diagram showing reflection characteristics of a light emitting display device depending on the angle.
FIG. 13 is a diagram showing various angle arrangements according to an embodiment.
FIG. 14 is a photograph of reflection characteristics according to angle.
FIG. 15 and FIG. 16 are diagrams showing reflection characteristics according to eccentricity.
FIG. 17 and FIG. 18 are diagrams showing a structure combining ellipses with different eccentricities.
FIG. 19 is a diagram showing a merged elliptical structure and its reflection characteristics according to an embodiment.
FIG. 20 is a plan view of a portion of a display panel according to an embodiment.
FIG. 21 and FIG. 22 are diagrams showing reflection characteristics according to eccentricity.
FIG. 23 to FIG. 25 are plan views of a portion of a display panel according to another embodiment.
FIG. 26 is a plan view showing the configuration of a unit pixel of one of the display panels according to an embodiment.
FIG. 27 and FIG. 28 are diagrams showing the effects according to pixel arrangement.
FIG. 29 and FIG. 30 are plan views of a portion of a display panel according to an embodiment.
FIG. 31 is a photograph of the reflection characteristics of the comparative example and the example of FIG. 30.
FIG. 32 is a plan view of a portion of the display panel in the embodiment of FIG. 29 arranged at various angles.
FIG. 33 and FIG. 34 are plan views of a portion of a display panel according to an embodiment.
FIG. 35 and FIG. 36 are plan views of a portion of a display panel according to an embodiment.
FIG. 37 is a photograph of the reflection characteristics of the comparative example and the example of FIG. 36.
FIG. 38 and FIG. 39 are plan views of a portion of a display panel according to an embodiment.
FIG. 40 is a diagram showing a structure combining ellipses with different eccentricities.
FIG. 41 is a diagram showing a merged elliptical structure and its reflection characteristics according to an embodiment.
FIG. 42 is a plan view of a portion of a display panel according to an embodiment.
FIG. 43 is a plan view including a color filter of a display area according to an embodiment.
FIG. 44 and FIG. 45 are schematic cross-sectional views of a display panel according to an embodiment.
FIG. 46 is a plan view showing color filters of a display area according to an embodiment.
FIG. 47 is a plan view of a portion of a display panel according to an embodiment.
FIG. 48 is a graph showing the transmittance according to the wavelength of the color filter.
FIG. 49 and FIG. 50 are cross-sectional views of a light emitting display device according to an embodiment.

### DETAILED DESCRIPTION OF THE DRAWINGS

Hereinafter, with reference to the attached drawings, various embodiments will be described in detail so that those skilled in the art can easily implement the present invention.

The invention may be implemented in many different forms and is not necessarily limited to the embodiments described herein.

To clearly explain the present invention, parts that are not relevant to the description may be omitted, and identical or similar components may be assigned the same reference numerals throughout the specification and the drawings.

In addition, while each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like.

In the drawing, the thicknesses of various layers may be enlarged for clarity.

Additionally, when a part, such as a layer, membrane, region, plate or component is said to be "above" or "on" another part, this means not only when it is "directly above" another part, but also when there is another part in between.

Conversely, when a part is said to be "directly on top" of another part, it means that there is no other part in between.

In addition, being "above" or "on" a reference part means being located above or below the reference part, and does not necessarily mean being located "above" or "on" it in the direction opposite to gravity.

In addition, throughout the specification, when a part is said to "include" a certain component, this means that it may further include other components rather than excluding other components, unless specifically stated to the contrary.

In addition, throughout the specification, when reference is made to "in a plan view," this means when the target portion is viewed from above, and when reference is made to "in cross-section," this means when a cross-section of the target portion is cut vertically and viewed from the side.

Also, throughout the specification, when something is said to be "connected," it does not only mean that two or more components are directly connected, but it can also include cases where two or more components are indirectly connected through other components, cases where they are physically connected or electrically connected, and even cases where parts that have been referred to by different names depending on their location or function, but are essentially one whole, are connected to each other.

In addition, throughout the specification, when a portion such as a wiring, layer, film, region, plate or component is said to "extend in the first or second direction," this does not mean only a straight line extending in that direction, but also a structure that extends overall along the first or second direction, and also includes a structure that is bent at some part, has a zigzag structure, or extends while including a curved structure.

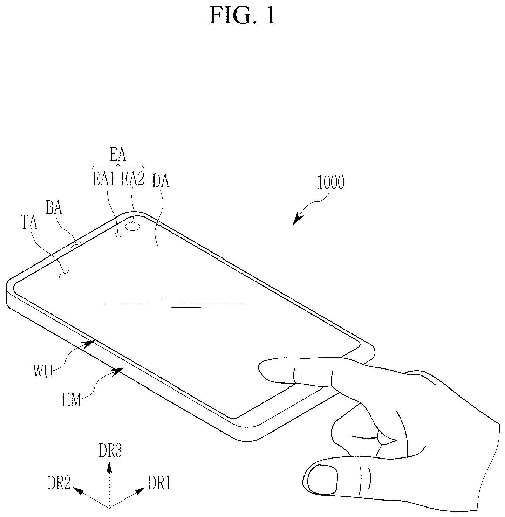

In addition, electronic devices (e.g., mobile phones, TVs, monitors, laptop computers, etc.) containing display devices, display panels, etc. described in the specification, or display devices, display panels, etc. manufactured by the manufacturing method described in the specification, included herein are also not excluded from the scope of rights of this specification. Below, the schematic structure of the display device through FIG. 1 to FIG. 3 will be examined.

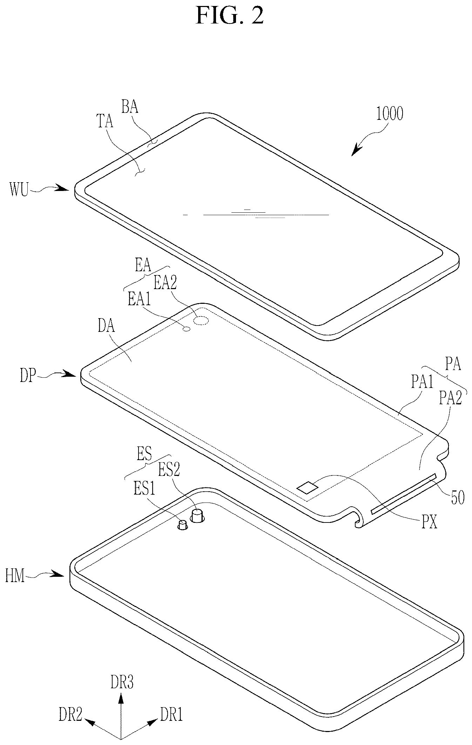

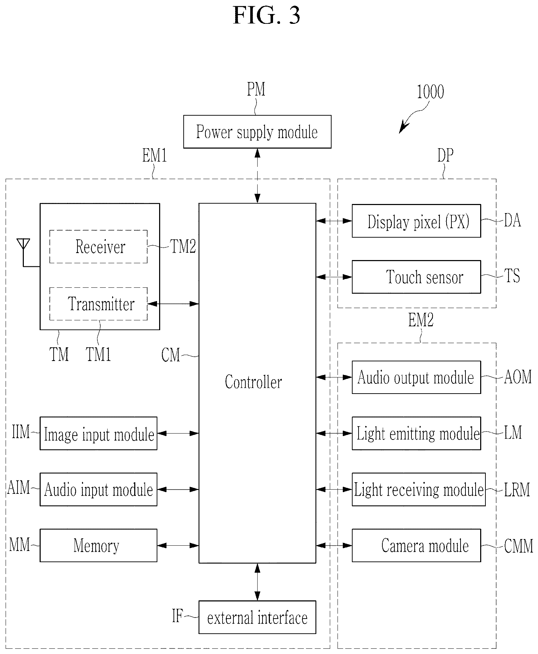

FIG. 1 is a schematic perspective view showing a use state of a display device according to an embodiment, FIG. 2 is an exploded perspective view of a display device according to an embodiment, and FIG. 3 is a block diagram of a display device according to an embodiment.

Referring to FIG. 1, a display device 1000, according to an embodiment, is a device that displays moving images or still images, and may be used in a mobile phone, a smart phone, a tablet personal computer, or a portable electronic devices such as communication terminals, electronic notebooks, e-book readers, portable multimedia player (PMP), navigation systems, ultra mobile PCs (UMPC), as well as televisions, laptops, computer monitors, digital billboards, internet of things (IOT) devices, etc., and it can be used as a display screen for various other products.

In addition, the display device 1000, according to one embodiment, is mounted on a wearable device such as a smart watch, a watch phone, a glasses-type display, and a head-mounted display HMD.

In addition, the display device 1000, according to one embodiment, includes a dashboard of a car, a center information display CID placed on the center fascia or dashboard of a car, and a room mirror display (a display instead of a side mirror of a car) can be used as entertainment for the back seat of a car, and as a display placed on the back of the front seat.

FIG. 1 shows the display device 1000 being used as a smart phone, for convenience of explanation.

The display device 1000 may display an image in the third direction DR3 on a display surface parallel to each of the first direction DR1 and the second direction DR2.

The display surface on which the image is displayed may correspond to the front surface of the display device 1000 and the front surface of the cover window WU.

Images may include static (e.g., still) images as well as dynamic (e.g., moving) images.

In this embodiment, the front (or top) and back (or bottom) surfaces of each member are defined based on the direction in which the image is displayed.

The front and back surfaces are opposed to each other in the third direction DR3, and the normal directions of each of the front and back surfaces may be parallel to the third direction DR3.

The separation distance between the front and back surfaces in the third direction DR3 may correspond to the thickness of the display panel in the third direction DR3.

The display device 1000, according to one embodiment, may detect a user's input (e.g., refers to a touch of the hand illustrated in FIG. 1).

The user's input may include various types of external inputs, such as a touch of a part of the user's body, light, heat, or pressure.

In one embodiment, the user's input is shown with the user's hand applied to the front.

However, the present invention is not necessarily limited to this.

The user's input may be provided in various forms, and the display device 1000 may also detect the user's input applied to the side or back of the display device 1000, depending on the structure of the display device 1000.

Referring to FIG. 1 and FIG. 2, the display device 1000 may include a cover window WU, a housing HM, a display panel DP, and an optical element ES.

In one embodiment, the cover window WU and the housing HM may be combined to form the exterior of the display device 1000.

The cover window WU may include an insulating panel.

For example, the cover window WU may be made of glass, plastic, or a combination thereof.

The front of the cover window WU may define the front of the display device 1000.

The transmission area TA may be an optically transparent area.

For example, the transmission area TA may be an area with a visible light transmittance of about 90% or more.

The blocking area BA may define the shape of the transmission area TA.

The blocking area BA is adjacent to the transmission area TA and may at least partially surround the transmission area TA.

The blocking area BA may be an area with relatively low light transmittance compared to the transmitting area TA.

The blocking area BA may include an opaque material that substantially blocks light.

The blocking area BA may have a predetermined color.

The blocking area BA may be defined by a bezel layer provided separately from the transparent substrate defining the transparent area TA, or may be defined by an ink layer formed by covering or coloring the transparent substrate.

The display panel DP may include a display pixel PX that displays an image and a driver 50, and the display pixel PX is located in the display area DA and the component area EA.

The display panel DP may include a front surface including a display area DA and a non-display area PA.

In one embodiment, the display area DA and the component area EA are areas where images are displayed, including pixels, and at the same time, a touch sensor may be located in the upper direction of the third direction DR3 of the pixels, which can be an area where external input is detected.

The transmission area TA of the cover window WU may at least partially overlap the display area DA and the component area EA of the display panel DP.

For example, the transmission area TA may overlap the front surface of the display area DA and the component area EA, or may overlap at least a portion of the display area DA and the component area EA.

Accordingly, the user can view the image through the transmission area TA or provide external input based on the image.

However, the present invention is not necessarily limited to this.

For example, the area where an image is displayed and the area where external input is detected may be separated from each other.

The non-display area PA of the display panel DP may at least partially overlap the blocking area BA of the cover window WU.

The non-display area PA may be an area covered by the blocking area BA.

The non-display area PA is adjacent to the display area DA, and may at least partially surround the display area DA.

An image is not displayed in the non-display area PA, and a driving circuit or driving wiring for driving the display area DA may be disposed.

The non-display area PA may include a first peripheral area PA1 located outside the display area DA and a second peripheral area PA2 including the driver 50, connection wiring, and a bending area.

In the embodiment of FIG. 2, the first peripheral area PA1 is located on the third side of the display area DA, and the second peripheral area PA2 is located on the remaining side of the display area DA.

In one embodiment, the display panel DP may be assembled in a flat state with the display area DA, component area EA, and non-display area PA facing the cover window WU.

However, the present invention is not necessarily limited to this.

A portion of the non-display area PA of the display panel DP may be curved.

At this time, part of the non-display area PA is directed toward the rear of the display device 1000, so that the blocking area BA visible on the front of the display device 1000 can be reduced, and in FIG. 2, the second peripheral area PA2 can be bent and placed on the back of the display area DA and then assembled.

Additionally, the component area EA of the display panel DP may include a first component area EA1 and a second component area EA2.

The first component area EA1 and the second component area EA2 may be at least partially surrounded by the display area DA.

The first component area EA1 and the second component area EA2 are shown spaced apart from each other, but are not necessarily limited to this and may be at least partially connected.

The first component area EA1 and the second component area EA2 may be areas in which an optical element (see ES in FIG. 2; hereinafter referred to as a component) that uses infrared rays, visible rays, or sound is disposed.

The display area (DA; hereinafter also referred to as the main display area) and the component area EA are formed with a plurality of light emitting diodes and a plurality of pixel circuit units that generate and transmit light emission current to each of the plurality of light emitting diodes.

Here, one light emitting diode and one pixel circuit part are called a pixel PX.

One pixel circuit unit and one light emitting diode may have a one-to-one ratio in the display area DA and the component area EA.

The first component area EA1 may include a transparent portion through which light and/or sound can be transmitted and a display portion including a plurality of pixels.

The transmission portion is located between adjacent pixels, and is composed of a layer through which light and/or sound can be transmitted.

The transmission portion may be located between adjacent pixels, and depending on the embodiment, a layer that does not transmit light, such as a light blocking layer, may overlap the first component area EA1.

The number of pixels (hereinafter referred to as resolution) per unit area of the pixels (hereinafter referred to as normal pixels) included in the display area DA and the number of pixels per unit area included in the first component area EA1 (hereinafter referred to as first component pixels) may be the same.

The second component area EA2 includes an area composed of a transparent layer so that light can pass through (hereinafter also referred to as a light transmission area), and the light transmission area does not have a conductive layer or a semiconductor layer and includes a light blocking material. For example, a pixel defining layer and/or a light blocking layer may have a structure that does not block light by including an opening that overlaps a position corresponding to the second component area EA2.

The number of pixels per unit area of the pixels included in the second component area EA2 (hereinafter also referred to as second component pixels) may be smaller than the number of pixels per unit area of the normal pixels included in the display area DA.

As a result, the resolution of the second component pixels may be lower than that of the normal pixels.

Depending on the embodiment, instead of a light blocking layer, a light blocking area in which at least two color filters are overlapped may be formed to block light in a specific wavelength range (for example, visible light, etc.).

Referring to FIG. 3, the display panel DP may further include a touch sensor TS in addition to the display area DA including the display pixels PX.

The display panel DP includes pixels PX, which are components that generate an image, and can be visible to the user through the transmission area TA.

Additionally, the touch sensor TS may be located on top of the pixels PX and may detect an external input.

The touch sensor TS can detect an external input provided to the cover window WU.

Referring again to FIG. 2, the second peripheral area PA2 may include a bending portion.

The display area DA and the first peripheral area PA1 may have a flat state substantially parallel to the plane defined by the first direction DR1 and the second direction DR2, and the second peripheral area PA2 may be extended from a flat state, pass through a bending portion, and then be in a flat state again.

As a result, at least a portion of the second peripheral area PA2 may be bent and assembled to be located on the rear side of the display area DA.

When at least a portion of the second peripheral area PA2 is assembled, it overlaps the display area DA in a plan view, so the blocking area BA of the display device 1000 may be reduced.

However, the present invention is not necessarily limited to this.

For example, the second peripheral area PA2 might not be bent.

The driver 50 may be mounted on the second peripheral area PA2, on the bending part, or located on one of both sides of the bending part.

The driver 50 may be provided in the form of a chip.

The driver 50 is electrically connected to the display area DA and the component area EA, and can transmit electrical signals to pixels in the display area DA and the component area EA.

For example, the driver 50 may provide data signals to the pixels PX arranged in the display area DA.

Alternatively, the driver 50 may include a touch driving circuit and may be electrically connected to the touch sensor TS disposed in the display area DA and/or the component area EA.

The driver 50 may include various circuits in addition to the above-described circuits or may be designed to provide various electrical signals to the display area DA.

The display device 1000 can have a pad part located at the end of the second peripheral area PA2, and can be electrically connected to a flexible printed circuit board FPCB including a drive chip by the pad part.

Here, the driving chip located on the flexible printed circuit board may include various driving circuits for driving the display device 1000 or a connector for power supply.

Depending on the embodiment, a rigid printed circuit board PCB may be used instead of a flexible printed circuit board.

The optical element ES may be disposed below the display panel DP.

The optical element ES may include a first optical element ES 1 overlapping the first component area EA1 and a second optical element ES2 overlapping the second component area EA2.

The first optical element ES1 may use infrared rays, and in this case, a layer that does not transmit light, such as a light blocking layer, may overlap the first component area EA1.

The first optical element ES1 may be an electronic element that uses light or sound.

For example, the first optical element ES1 is a sensor that receives and uses light such as an infrared sensor, a sensor that outputs and detects light or sound to measure distance or recognize a fingerprint, etc., or a small lamp that outputs light, and it may be a speaker that outputs sound, etc.

In the case of electronic elements that use light, light of various wavelength bands, such as visible light, infrared light, and ultraviolet light, can be used.

The second optical element ES2 is at least one of a camera, an IR camera, a dot projector, an infrared illuminator, and a time-of-flight sensor.

Referring to FIG. 3, the display device 1000 may include a display panel DP, a power supply module PM, a first electronic module EM1, and a second electronic module EM2.

The display panel DP, the power supply module PM, the first electronic module EM1, and the second electronic module EM2 may be electrically connected to each other.

FIG. 3 illustrates display pixels and a touch sensor TS located in the display area DA among the configuration of the display panel DP.

The power supply module PM can supply power required for the overall operation of the display device 1000.

The power supply module PM may include a conventional battery module.

The first electronic module EM1 and the second electronic module EM2 may include various functional modules for operating the display device 1000.

The first electronic module EM1 may be mounted directly on the motherboard electrically connected to the display panel DP, or may be mounted on a separate board and electrically connected to the motherboard through a connector.

The first electronic module EM1 may include a control module CM, a wireless communication module TM, an image input module IIM, an audio input module AIM, a memory MM, and an external interface IF.

Some of the modules might not be mounted on the motherboard, but may be electrically connected to the motherboard through a flexible printed circuit board connected thereto.

The control module CM may control the overall operation of the display device 1000. The control module CM may be a microprocessor.

For example, the control module CM activates or deactivates the display panel DP.

The control module CM can control other modules, such as an image input module IIM or an audio input module AIM, based on the touch signal received from the display panel DP.

The wireless communication module TM can transmit/receive wireless signals to and from other terminals using a Bluetooth or Wi-Fi line.

The wireless communication module TM can transmit/receive voice signals using a general communication line.

The wireless communication module TM includes a transmitter TM1 that modulates and transmits a signal to be transmitted, and a receiver TM2 that demodulates the received signal.

The image input module IIM can process video signals and convert them into video data that can be displayed on the display panel DP.

The audio input module AIM can receive external acoustic signals through a microphone in recording mode, voice recognition mode, etc. and convert them into electrical voice data.

The external interface IF may serve as an interface connected to an external charger, wired/wireless data port, card socket (e.g., memory card, SIM/UIM card), etc.

The second electronic module EM2 may include an audio output module AOM, a light emitting module LM, a light receiving module LRM, and a camera module CMM, at least some of which include optical elements ES, and it may be located on the back of the display panel DP, as shown in FIG. 1 and FIG. 2.

The optical element ES may include a light emitting module LM, a light receiving module LRM, and a camera module CMM.

Additionally, the second electronic module EM2 can be directly mounted on the motherboard, it can be mounted on a separate board and electrically connected to the display panel DP through a connector, or it can be electrically connected to the first electronic module EM1.

The audio output module AOM can convert audio data received from the wireless communication module TM or audio data stored in the memory MM and output.

The light emitting module LM can generate and output light.

The light emitting module LM can output infrared rays.

For example, the light emitting module LM may include an LED device.

For example, a light receiving module LRM can detect infrared light.

The light receiving module LRM may be activated when infrared rays above a certain level are detected.

The light receiving module LRM may include a CMOS sensor.

After the infrared light generated in the light emitting module LM is output, it is reflected by an external subject (e.g., a user's finger or face), and the reflected infrared light may be incident on the light receiving module LRM.

The camera module CMM can capture external images.

In one embodiment, the optical element ES may additionally include a light detection sensor or a heat detection sensor.

The optical element ES can detect an external subject received through the front or provide a sound signal such as voice through the front.

Additionally, the optical element ES may include a plurality of components and is not necessarily limited to any one embodiment.

Again, referring to FIG. 2, the housing HM may be combined with the cover window WU.

The cover window WU may be disposed on the front of the housing HM.

The housing HM can be combined with the cover window WU to provide a predetermined accommodation space.

The display panel DP and the optical element ES may be accommodated in a predetermined accommodation space provided between the housing HM and the cover window WU.

The housing HM may include a material with relatively high rigidity.

For example, the housing HM may include a plurality of frames and/or plates made of glass, plastic, or metal, or a combination thereof.

The housing HM can stably protect the components of the display device 1000 accommodated in the internal space from external shock.

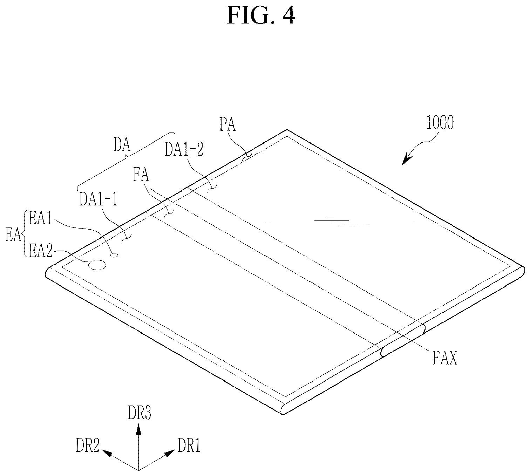

Hereinafter, the structure of the display device 1000, according to an embodiment, will be looked at through FIG. 4.

FIG. 4 is a perspective view schematically showing a light emitting display device according to an embodiment.

To the extent that an element is not described in detail with respect to this figure, it may be understood that the element is at least similar to a corresponding element that has been described elsewhere within the present disclosure. The embodiment of FIG. 4 shows a foldable display device in which the display device 1000 is folded through the folding axis FAX.

Referring to FIG. 4, in one embodiment, the display device 1000 may be a foldable display device.

The display device 1000 may be folded outward or inward based on the folding axis FAX.

When folded outward based on the folding axis FAX, the display surfaces of the display device 1000 are positioned on the outside in the third direction DR3 so that images can be displayed in both directions.

If it is folded inward based on the folding axis FAX, the display surface might not be visible to the user.

In one embodiment, the display device 1000 may include a display area DA, a component area EA, and a non-display area PA.

The display area DA may be divided into a 1-1 display area DA1-1, a 1-2 display area DA1-2, and a folding area FA.

The 1-1 display area DA1-1 and the 1-2 display area DA1-2 may be located on the left and right sides, respectively, based on (or centered on) the folding axis FAX, and the folding area FA may be located between display area DA1-1 and the 1-2 display area DA1-2.

At this time, when folded outward based on the folding axis FAX, the 1-1 display area DA1-1 and the 1-2 display area DA1-2 are located on both sides in the third direction (DR3), this allows images to be displayed in both directions.

Additionally, when folded inward based on the folding axis FAX, the 1-1 display area DA1-1 and the 1-2 display area DA1-2 might not be visible to the user.

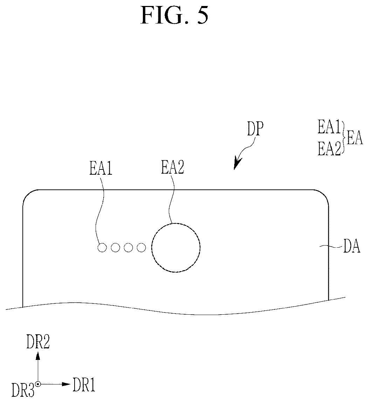

FIG. 5 is an enlarged plan view of a partial area of a light emitting display device according to an embodiment.

FIG. 5 shows a portion of a light emitting display panel DP of a light emitting display device according to an embodiment, and is shown using a display panel for a mobile phone.

The display area DA is located on the front of the light emitting display panel DP, and a component area EA is also located within the display area DA.

For example, the component area EA may include a first component area EA1 and a second component area EA2.

Additionally, in the embodiment of FIG. 5, the first component area EA1 is located adjacent to the second component area EA2.

In the embodiment of FIG. 5, the first component area EA1 is located to the left of the second component area EA2.

The location and number of first component areas EA1 may vary depending on the embodiment. In FIG. 5, the second optical element ES2 corresponding to the second component area EA2 may be a camera, and the first optical element ES1 corresponding to the first component area EA1 may be an optical sensor.

The display area DA is formed with a plurality of light emitting diodes and a plurality of pixel circuit units that generate and transmit light emitting current to each of the plurality of light emitting diodes.

Here, one light emitting diode and one pixel circuit part are called a pixel PX.

In the display area DA, one pixel circuit unit and one light emitting diode have a one-to-one arrangement.

The display area DA is hereinafter also referred to as the "normal display area."

Although the structure of the light emitting display panel DP below the cutting line is not shown in FIG. 5, the display area DA may be located below the cutting line.

The light emitting display panel DP according to the embodiment can be largely divided into a lower panel layer and an upper panel layer.

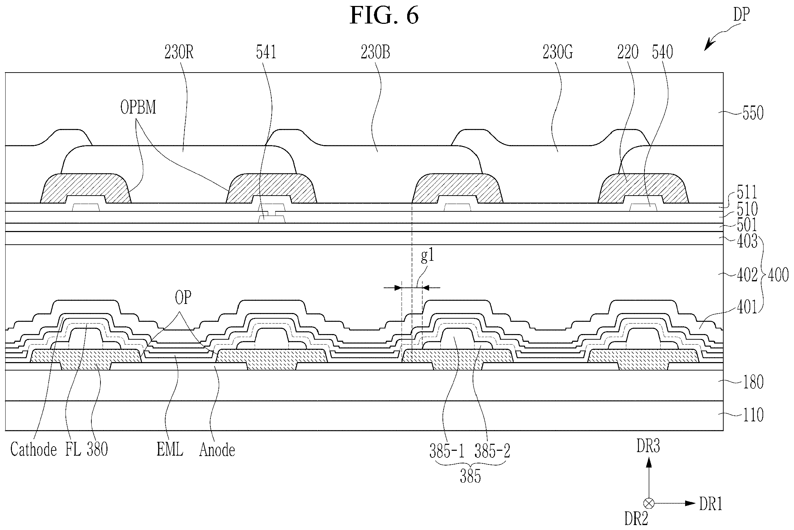

The lower panel layer is the part where the light emitting diode and the pixel circuit unit that make up the pixel are located, and may even include an encapsulation layer (see 400 in FIG. 6) covering it.

For example, the lower panel layer consists of an anode, a pixel defining layer (see 380 in FIG. 6), a light emitting layer (see EML in FIG. 6), and a spacer (see 385 in FIG. 6) from the substrate (see 110 in FIG. 6) to the encapsulation layer, and it also includes a functional layer (see FL in FIG. 6), a cathode (see cathode in FIG. 6), an insulating film between the substrate and anode, a semiconductor layer, and a conductive layer.

The upper panel layer is a part located above the encapsulation layer and includes a sensing insulating layer capable of detecting touch (see 501, 510, and 511 in FIG. 6) and a plurality of sensing electrodes (see 540 and 541 in FIG. 6), and may include a light blocking layer (see 220 in FIG. 6), a color filter (see 230 in FIG. 6), and a planarization layer (see 550 in FIG. 6).

The first component area EA1 may include only a transparent layer to allow light to pass through, might not have a conductive layer or semiconductor layer to allow light to pass through, and may have an optical sensor area in the lower panel layer. An opening (hereinafter referred to as an additional opening) is formed in a position corresponding to the first component area EA1 in the pixel defining layer, light blocking layer, and color filter layer of the upper panel layer, so that it can have a structure that does not block light.

Even if the optical sensor area is located in the lower panel layer, if there is no corresponding opening in the upper panel layer, it may be the display area DA other than the first component area EA1.

One first component area EA1 may include a plurality of adjacent optical sensor areas, and in this case, pixels adjacent to the optical sensor area may be included in the first component area EA1.

When the first optical element ES1 corresponding to the first component area EA1 uses infrared rays rather than visible rays, the first component area EA1 overlaps the light blocking layer 220 that blocks visible rays.

The second component area EA2 may include a second component pixel and a light transmission area, and the space between adjacent second component pixels may be a light transmission area.

A peripheral area may be further located outside the display area DA.

In addition, although FIG. 5 shows a display panel for a mobile phone, this embodiment can be applied to any display panel in which optical elements can be located on the back of the display panel, and it can also be a flexible display device.

In the case of a foldable display device among flexible display devices, the second component area EA2 and the first component area EA1 may be formed in positions different from those of FIG. 5.

Hereinafter, the structure of the light emitting display panel DP according to an embodiment will be described with reference to FIG. 6.

FIG. 6 is a schematic cross-sectional view of a display panel according to an embodiment.

The light emitting display panel DP according to one embodiment can display an image by forming light emitting diodes on a substrate 110, can detect a touch by including a plurality of sensing electrodes 540 and 541, and has a light blocking layer 220. The light emitted from the light emitting diode, including the light blocking layer 220 and the color filters 230R, 230G, 230B, also has the color characteristics of the color filters 230R, 230G, 230B.

In addition, a polarizer is not disposed on the front of the light emitting display panel DP according to one embodiment, and instead, the pixel defining layer 380 is formed of a black organic material, and the light blocking layer 220 and the color filter 230 are disposed on the top so that even if external light is incident inside, it is reflected from the anode, etc. and is not transmitted to the user.

A detailed look at the light emitting display panel DP according to an embodiment is as follows.

The substrate 110 may include a material that has rigid properties and does not bend, such as glass, or may include a flexible material that can bend, such as plastic or polyimide.

A plurality of thin film transistors are disposed on the substrate 110, but they are omitted in FIG. 6 and only the organic layer 180 covering the thin film transistors is shown.

One pixel is formed with a light emitting diode and a pixel circuit portion in which a plurality of transistors and capacitors are formed to transmit light emitting current to the light emitting diode.

In FIG. 6, the pixel circuit unit is not shown, and the structure of the pixel circuit unit may vary depending on the embodiment.

In FIG. 6, the organic layer 180 covering the pixel circuit portion is shown first.

A light emitting diode including an anode, a light emitting layer EML, and a cathode is located on the organic layer 180.

An anode may include a single layer containing a transparent conductive oxide film and a metal material or a multiple layer containing these.

The transparent conductive oxide film may include indium tin oxide (ITO), poly-ITO, indium zinc oxide (IZO), indium gallium zinc oxide (IGZO), and indium tin zinc oxide (ITZO), and the metal material may include silver (Ag), molybdenum (Mo), copper (Cu), gold (Au), and aluminium (Al).

The light emitting layer EML may be formed of an organic light emitting material, and adjacent light emitting layers EML may display different colors.

Depending on the embodiment, each light emitting layer EML may display light of the same color due to the color filters 230R, 230G, 230B located at the top.

Depending on the embodiment, the light emitting layer EML may have a structure in which a plurality of light emitting layers are stacked (also called a tandem structure).

The pixel defining layer 380 is located on the organic layer 180 and the anode. The pixel defining layer 380 has an opening OP (hereinafter referred to as the first opening), and the opening OP exposes the anode, the light emitting layer EML overlaps a part of the anode and is located on the anode exposed by the opening OP.

The light emitting layer EML can be located only within the opening OP of the pixel defining layer 380 and is separated from the adjacent light emitting layer EML by the pixel defining layer 380.

The pixel defining layer 380 may be formed of a negative-type black organic material.

The black organic material may include a light blocking material, and the light blocking material may include carbon black, carbon nanotubes, a resin or paste containing black dye, metal particles such as nickel, aluminium, molybdenum, and alloys thereof, metal oxide particles, metal nitride particles(e.g., chromium nitride), and the like.

The pixel defining layer 380 contains a light blocking material and is black in color, and may have characteristics of absorbing/blocking light rather than reflecting it.

Because the negative type uses organic materials, it can have the property of removing the part covered by the mask.

A spacer 385 is disposed on the pixel defining layer 380.

The spacer 385 includes a first part 385-1 located in a high and narrow area, and a second part 385-2 located in a short and wide area.

In FIG. 6, the first part 385-1 and the second part 385-2 are shown separated by dotted lines within the spacer 385.

Here, the first part 385-1 may secure rigidity against pressing pressure by enhancing scratch strength.

The second portion 385-2 may allow contact between the pixel defining layer 380 and the upper functional layer FL.

The first part 385-1 and the second part 385-2 are made of the same material, and may be made of a positive-type photosensitive organic material, for example, photosensitive polyimide PSPI.

Because it has positive characteristics, parts not covered by the mask can be removed.

The spacer 385 is transparent so that light can be transmitted and/or reflected.

The pixel defining layer 380 may be formed as a negative type, and the spacer 385 may be formed as a positive type, and depending on the embodiment, they may include the same materials.

At least a portion of the upper surface of the pixel defining layer 380 is covered by the spacer 385, the edge of the second portion 385-2 has a structure in which the edge of the pixel defining layer 380 is spaced apart from the edge of the second portion 385-2, and a portion of the pixel defining layer 380 has a structure that is not covered by the spacer 385.

The second part 385-2 covers even the upper surface of the pixel defining layer 380 where the first part 385-1 is not located, thereby strengthening the adhesion characteristics between the pixel defining layer 380 and the functional layer FL.

In this embodiment, the spacer 385 is located only in the area overlapping the light blocking layer 220, to be described later, so when viewed from the front of the display panel DP, the spacer 385 might not be visible as it is hidden by the light blocking layer 220.

The functional layer FL is located on the spacer 385 and the exposed pixel defining layer 380, and the functional layer FL is disposed on the entire surface of the light emitting display panel DP or may be formed in a partial area-for example, in all areas except the light transmitting area of the second component area EA2.

The functional layer FL may include an electron injection layer, an electron transport layer, a hole transport layer, and a hole injection layer, and the functional layer FL may be located above and below the light emitting layer EML.

For example, the hole injection layer, hole transport layer, light emitting layer EML, electron transport layer, electron injection layer, and cathode are located sequentially on the anode to form the hole injection layer and hole transport in the functional layer FL, and the layer may be located below the light emitting layer EML, and the electron transport layer and the electron injection layer may be located on top of the light emitting layer EML.

The spacer 385 can reduce the defect rate due to pressing pressure by increasing the scratch resistance of the light emitting display panel DP, and according to the embodiment, it can increase the adhesion with the functional layer FL located at the top of the spacer 385 to prevent ambient moisture and air from entering.

In addition, high adhesive strength may eliminate the problem of poor adhesion between layers when the light emitting display panel DP has flexible characteristics and is folded and unfolded.

The cathode may be formed as a light transmitting electrode or a reflective electrode.

Depending on the embodiment, the cathode may be a transparent or translucent electrode, and may be lithium (Li), calcium (Ca), lithium/calcium fluoride (LiF/Ca), lithium/aluminium fluoride (LiF/Al), aluminium (Al), silver (Ag), magnesium (Mg), and their compounds can be formed as a metal thin film with a small work function.

Additionally, a transparent conductive oxide (TCO) film, such as indium tin oxide (ITO), indium zinc oxide (IZO), zinc oxide (ZnO), or indium oxide (In₂O₃), may be further disposed on the metal thin film.

The cathode may be formed integrally over the entire surface of the light emitting display panel DP.

An encapsulation layer 400 is located on the cathode.

The encapsulation layer 400 includes at least one inorganic layer and at least one organic layer, and in FIG. 6, it has a triple layer structure including a first inorganic encapsulation layer 401, an organic encapsulation layer 402, and a second inorganic encapsulation layer 403.

The encapsulation layer 400 may protect the light emitting layer EML made of an organic material from ambient moisture or oxygen that may enter.

Depending on the embodiment, the encapsulation layer 400 may include a structure in which an inorganic layer and an organic layer are further sequentially stacked.

Sensing insulating layers 501, 510, 511 and a plurality of sensing electrodes 540, 541 are positioned on the encapsulation layer 400 for touch detection.

In the embodiment of FIG. 6, two detection electrodes (540, 541) are used to detect touch in a capacitive type, but according to the embodiment, touch can also be detected by using only one detection electrode in a self-cap method.

The plurality of sensing electrodes 540 and 541 may be insulated with a second sensing insulating layer 510 interposed therebetween, and a lower sensing electrode 541 is located on the first sensing insulating layer 501, and the second sensing insulating layer 510 is interposed between the plurality of sensing electrodes 540 and 541, an upper sensing electrode 540 is located on the layer 510, and the upper sensing electrode 540 is covered by a third sensing insulating layer 511.

The plurality of sensing electrodes 540 and 541 may be electrically connected through an opening located in the second sensing insulating layer 510.

Here, the sensing electrodes 540 and 541 are made of metal or metal alloy such as aluminium (Al), copper (Cu), silver (Ag), gold (Au), molybdenum (Mo), titanium (Ti), and tantalum (Ta), and may include a single layer or multiple layers.

A light blocking layer 220 and color filters 230R, 230G, 230B are positioned on the third sensing insulating layer 511.

The light blocking layer 220 may overlap the sensing electrodes 540 and 541 in a plane, and may be positioned not to overlap the anode in a plane.

This is to ensure that the anode and the light emitting layer EML capable of displaying an image are not obscured by the light blocking layer 220 and the sensing electrodes 540 and 541.

Referring to FIG. 6, the light blocking layer 220 is located only in the area overlapping the pixel defining layer 380 in a plan view, and one side of the light blocking layer 220 is arranged inward from one corresponding side of the pixel defining layer 380.

The light blocking layer 220 also has a second opening OPBM (hereinafter referred to as the second opening), and the area of the second opening OPBM of the light blocking layer 220 is larger than the opening OP of the pixel defining layer 380. The opening OP of the pixel defining layer 380 may be located in a planar view, and the light blocking layer 220 may also be located within the second opening OPBM.

In addition, one side of the spacer 385 is disposed inward at a predetermined distance g1 from the corresponding side of the pixel defining layer 380, and the spacer 385 is also disposed on one side of the light blocking layer 220.

As a result, when viewed from the front of the display panel DP, the spacer 385 may be obscured by the light blocking layer 220 and might not be visible.

When external light is incident, it may pass through the second opening OPBM of the light blocking layer 220 and then be reflected on the sidewall of the opening OP of the pixel defining layer 380.

The sidewall of the opening OP of the pixel defining layer 380 is curved, and color separation occurs depending on the position of reflection, so that the reflected light can appear in various colors, such as a rainbow.

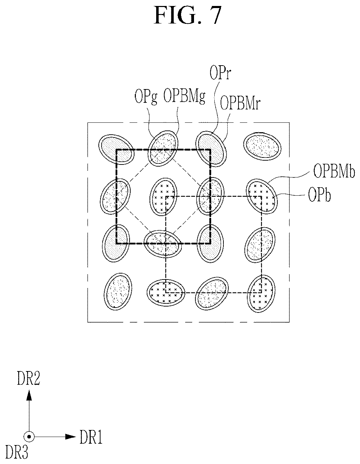

Since this color-separated reflected light can easily be seen by the user and deteriorate the display quality, in the embodiments, the second opening OPBM of the light blocking layer 220 and the opening OP of the pixel defining layer 380 each have an elliptical shape, as in the embodiments of FIG. 7, etc., the direction of the ellipse or the eccentricity of the ellipse is arranged in various ways to reduce color separation or to allow the white reflected light to be recognized.

This will be discussed in more detail below in FIG. 7.

Color filters 230R, 230G, 230B are positioned on the sensing insulating layers 501, 510, and 511 and the light blocking layer 220.

The color filters 230R, 230G, 230B are a red color filter 230R that transmits red light, a green color filter 230G that transmits green light, and a blue color filter 230B that transmits blue light.

Each color filter 230R, 230G, 230B can overlap the anode of the light emitting diode in a plan view, and the color filters 230R, 230G, 230B of one color can be filled in the second opening OPBM of the light blocking layer 220.

Some of the color filters 230R, 230G, 230B may also be located on the upper surface of the light blocking layer 220.

Since the light emitted from the light emitting layer EML may change to a corresponding color as it passes through a color filter, all light emitted from the light emitting layer EML may have the same color.

However, the light emitting layer EML may emit light of different colors, and the displayed color can be strengthened by passing through a color filter of the same color.

The light blocking layer 220 may be positioned between each color filter 230R, 230G, 230B.

Depending on the embodiment, the color filters 230R, 230G, 230B may be replaced with a color conversion layer or may further include a color conversion layer.

The color conversion layer may include quantum dots.

A planarization layer 550 covering the color filters 230R, 230G, 230B is positioned on the color filters 230R, 230G, 230B.

The planarization layer 550 is used to planarize the upper surface of the light emitting display panel and may be a transparent organic insulating film containing polyimide, polyamide, acrylic resin, benzocyclobutene, and/or phenol resin.

Depending on the embodiment, a low refractive layer and an additional planarization layer may be further positioned on the planarization layer 550 to increase front visibility and light output efficiency of the display panel.

Light can be refracted and emitted toward the front by the low refractive layer and the additional flattening layer with high refractive characteristics.

In this case, depending on the embodiment, the planarization layer 550 may be omitted and a low refractive layer and an additional planarization layer may be located directly on the color filter 230.

In this embodiment, a polarizer is not included on top of the planarization layer 550.

The polarizer can prevent display quality from deteriorating when external light is incident and reflected by the anode or the sidewall of the opening OP of the pixel defining layer 380, which is visible to the user.

However, the polarizer has the disadvantage of consuming more power to display a certain luminance by not only reducing the reflection of external light but also reducing the light emitted from the light emitting layer EML.

To reduce power consumption, the light emitting display device of this embodiment might not include a polarizer.

In addition, in this embodiment, the side of the anode is covered with the pixel defining layer 380 to reduce the degree of reflection from the anode, and a light blocking layer 220 is also formed to reduce the degree of incident light, thereby reducing the amount of light incident on the anode since it already contains a structure that prevents deterioration of display quality.

Therefore, there is no need to separately form the polarizer on the front of the light emitting display panel DP.

Hereinafter, the second opening OPBM of the light blocking layer 220 and the opening OP of the pixel defining layer 380 will be described through the structure of the light emitting display panel DP formed in the display area DA through FIG. 7 to FIG. 9, and an embodiment will be examined in which each opening (also called the first opening) has an oval shape.

FIG. 7 to FIG. 9 are plan views of a portion of a display panel according to an embodiment.

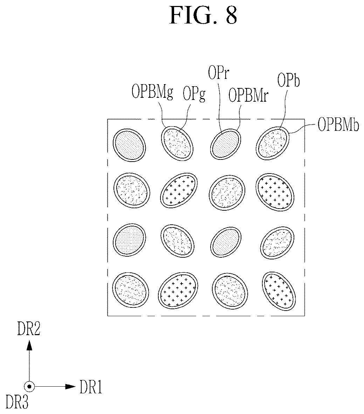

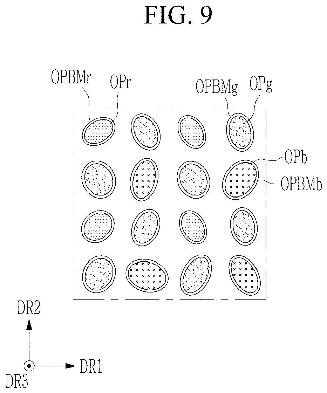

FIG. 7 to FIG. 9 each show different embodiments, and FIG. 7 shows an embodiment in which the second opening OPBM of the light blocking layer 220 and the opening OP of the pixel defining layer 380 are arranged at various angles, for example, FIG. 8 shows an embodiment in which the second opening OPBM of the light blocking layer 220 and the opening OP of the pixel defining layer 380 are formed at various eccentricities, and FIG. 9 shows the second opening OPBM of the light blocking layer 220, in an embodiment in which the second opening OPBM and the opening OP of the pixel defining layer 380 have various angles and are formed with various eccentricities.

In FIG. 7 to FIG. 9, the opening OP of the pixel defining layer 380 and the second opening OPBM of the light blocking layer 220 corresponding to each light emitting layer based on the light emitting layer displaying the three primary colors of red, green, and blue are shown divided into openings OPr, OPg, OPb and second openings OPBMr, OPBMg, OPBMb.

Here, r, g, and b may correspond to red, green, and blue, respectively.

Additionally, in the embodiments of FIG. 7 to FIG. 9, a unit pixel includes two light emitting areas of one color and a total of four light emitting areas.

For example, one unit pixel includes four adjacent light emitting areas, and the four light emitting areas include two light emitting areas of the first color among the three-color light emitting areas, and the remaining light emitting areas of the second and third colors, each light emitting area may be included one at a time.

In the embodiment of FIG. 7 to FIG. 9, among the four light emitting areas, two green-light emitting areas are included, and one red-light emitting area and one blue-light emitting area are included.

Hereinafter, this embodiment is also referred to as a green divided unit pixel.

Additionally, referring to the dotted line in FIG. 7, four adjacent green-light emitting areas have a diamond shape, and four adjacent red- and blue-light emitting areas each have a rectangular shape.

Although not shown in dotted lines in the embodiments of FIG. 8 and FIG. 9, they are in the same position as in FIG. 7.

First, the planar structures of the openings OPr, OPg, OPb of the pixel defining layer 380 and the second openings OPBMr, OPBMg, OPBMb of the light blocking layer 220 will be examined in detail through FIG. 7.

In FIG. 7, the openings OPr, OPg, OPb of the pixel defining layer 380 and the second openings OPBMr, OPBMg, OPBMb of the light blocking layer 220 each have an oval planar shape with the same eccentricity.

For example, the red opening OPr, green opening OPg, and blue opening OPb of the pixel defining layer 380 may all be ellipses with the same eccentricity.

Additionally, the red second opening OPBMr, the green second opening OPBMg, and the blue second opening OPBMb of the light blocking layer 220 may all be ellipses having the same eccentricity.

Here, the eccentricity of the openings OPr, OPg, OPb of the pixel defining layer 380 and the second openings OPBMr, OPBMg, OPBMb of the light blocking layer 220 may have a value of 0.2 or more and 0.85 or less.

Here, the ellipse has two foci, can have a shape connecting points where the sum of the distances to the two foci is constant, and can have a major axis and a minor axis.

The eccentricity of an ellipse is the distance between two foci divided by the length of the major axis.

When the eccentricity is 0, it is a circle, and when it is 1, it forms a parabola, so an ellipse has an eccentricity value that is greater than 0 and less than 1.

The openings OPr, OPg, OPb of one pixel defining layer 380 correspond to the second openings OPBMr, OPBMg, OPBMb of one light blocking layer 220.

For example, the openings OPr, OPg, OPb of the pixel defining layer 380 corresponding to each of the second openings OPBMr, OPBMg, OPBMb of the light blocking layer 220 are located in each of the second openings OPBMr, OPBMg, OPBMb of the light blocking layer 220. The corresponding second openings OPBMr, OPBMg, OPBMb of the light blocking layer 220 and the corresponding openings OPr, OPg, OPb of the pixel defining layer 380 may overlap each other in a plan view and have a constant horizontal distance from each other, and the second openings OPBMr, OPBMg, OPBMb of the corresponding two light blocking layers 220 and the openings OPr, OPg, OPb of the pixel defining layer 380 may have an elliptical shape with the major axes at the same angle.

Here, the horizontal gap between the second openings OPBMr, OPBMg, OPBMb of the light blocking layer 220 and the corresponding openings OPr, OPg, OPb of the pixel defining layer 380 may be greater than 0 µm and less than or equal to 20 µm, the horizontal gap may change depending on the thickness of the layer (e.g., encapsulation layer) located between the two in the cross-section, and the encapsulation layer may have a thickness of about 6 µm.

Depending on the embodiment, the major axis directions of the corresponding second openings OPBMr, OPBMg, OPBMb of the light blocking layer 220 and the openings OPr, OPg, OPb of the pixel defining layer 380 may be different due to process errors, etc., can form an angle, and can have an angle of 0 degrees or more and 20 degrees or less.

In the embodiment of FIG. 7, the pixel defining layer 380 can have four or more angles formed by the major axis of each of the plurality of openings OPr, OPg, OPb, and also, the angle formed by the major axis can be arranged at intervals of 45 degrees or less.

As an example, looking at specific angle relationships focusing on an embodiment with five angles, the relationship is as follows.

The embodiment with five angles is formed at intervals of 36 degrees along the major axis, so if one major axis has 0 degrees based on the first direction DR1, it has angles of 36 degrees, 72 degrees, 108 degrees, and 144 degrees, for a total of five angles.

The distance between the angles of the major axis can be checked by dividing the angle of 180 degrees by 5, which is the number of directions. This is because the two angles with an angle of 180 degrees out of 360 degrees have substantially the same direction of the major axis of the ellipse. This may mean calculating by dividing by the number based on 180 degrees.

The plurality of second openings OPBMr, OPBMg, OPBMb of the light blocking layer 220 can have angles of four or more degrees each, and also, the angles formed by the major axis can be arranged at intervals of 45 degrees or less.

As described above, the angle formed by the major axis of the plurality of openings OPr, OPg, OPb of the pixel defining layer 380 or the plurality of second openings OPBMr, OPBMg, OPBMb of the light blocking layer 220 is 45 degrees or less, and they can be placed at equal intervals.

However, depending on the embodiment, the angle formed by the major axis of each opening may be one of 45 degrees or less and may be arranged at irregular intervals.

The embodiment in which the major axes of the openings are arranged at irregular intervals may be intentionally arranged to reduce the diffraction pattern, or may be arranged at irregular intervals due to processing errors.

To make a unit pixel that includes openings of red, green, and blue having a square structure, it may be appropriate to form it by distinguishing the number corresponding to the square of an integer for the angle of the major axis, for example, 2², 3², 4², 5², etc.

Here, the unit pixel may include one each of red, green, and blue openings, and a plurality of openings of one color-for example, green openings-may be formed.

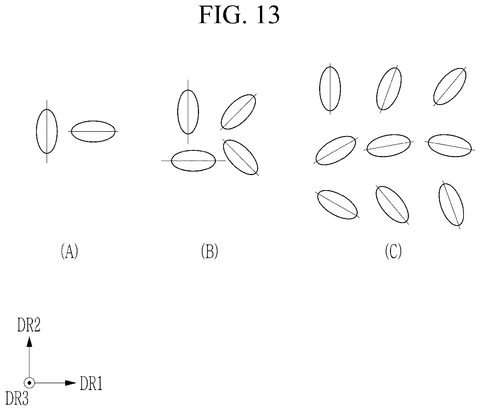

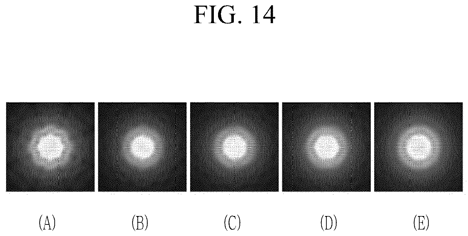

The plurality of openings OPr, OPg, OPb of the pixel defining layer 380 or the plurality of second openings OPBMr, OPBMg, OPBMb of the light blocking layer 220 have four or more or are spaced at an angle of 45 degrees or less, when arranged, less color separation of external light occurs or a constant diffraction pattern or color separation occurs regardless of the angle, which will be examined in more detail in FIG. 13 and FIG. 14.

The embodiment of FIG. 8 will be described below.

FIG. 8 shows an embodiment in which the second openings OPBMr, OPBMg, OPBMb of the light blocking layer 220 and the openings OPr, OPg, OPb of the pixel defining layer 380 have oval shapes with two or more different eccentricities.

Depending on the embodiment, each opening of the same color may have an oval shape with an eccentricity of 2 or more (i.e. there are 2 or more different eccentricities by opening of the same color).

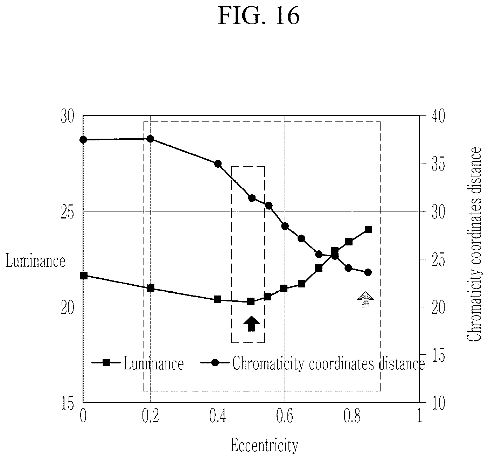

Here, referring to FIG. 16, the eccentricity of the oval shape may range from 0.2 to 0.85.

In FIG. 8, the major axis direction of the ellipse has only two directions forming 45 degrees with respect to the first direction DR1 or the second direction DR2, and depending on the embodiment, unlike FIG. 7, it may have four or fewer directions.

Through FIG. 8, the planar structures of the openings OPr, OPg, OPb of the pixel defining layer 380 and the second openings OPBMr, OPBMg, OPBMb of the light blocking layer 220 will be examined in detail.

In FIG. 8, the openings OPr, OPg, OPb of the pixel defining layer 380 and the second openings OPBMr, OPBMg, OPBMb of the light blocking layer 220 have an elliptical planar shape and are oriented in the first direction DR1 or the elliptical major axis directions are arranged only in two directions forming 45 degrees with respect to the second direction DR2.

Each of the red opening OPr, green opening OPg, and blue opening OPb of the pixel defining layer 380 may be formed as an ellipse with at least two different eccentricities.

In addition, the red second opening OPBMr, the green second opening OPBMg, and the blue second opening OPBMb of the light blocking layer 220 may each be formed as an ellipse having at least two different eccentricities.

In addition, in the embodiment of FIG. 8, the openings OPr, OPg, OPb of the pixel defining layer 380 of the same color may have an elliptical planar shape with at least two different eccentricities, and the same color light blocking the second openings OPBMr, OPBMg, OPBMb of the light blocking layer 220 may also have an oval planar shape with at least two different eccentricities.

The openings OPr, OPg, OPb of one pixel defining layer 380 correspond to the second openings OPBMr, OPBMg, OPBMb of one light blocking layer 220.

For example, the openings OPr, OPg, OPb of the pixel defining layer 380 corresponding to each of the second openings OPBMr, OPBMg, OPBMb of the light blocking layer 220, are located in each of the second openings OPBMr, OPBMg, OPBMb of the light blocking layer 220.

The corresponding second openings OPBMr, OPBMg, OPBMb of the light blocking layer 220 and the corresponding openings OPr, OPg, OPb of the pixel defining layer 380 may overlap each other in a plan view and have a constant horizontal distance from each other, and the major axis directions of the oval shape may be formed at the same angle.

Here, the horizontal gap between the second openings OPBMr, OPBMg, OPBMb of the light blocking layer 220 and the corresponding openings OPr, OPg, OPb of the pixel defining layer 380 may be greater than 0 µm and less than or equal to 20 µm, and the horizontal spacing may change depending on the thickness of the layer (for example, the encapsulation layer) located between the two in the cross-section.

Depending on the embodiment, the major axis directions of the corresponding second openings OPBMr, OPBMg, OPBMb of the light blocking layer 220 and the openings OPr, OPg, OPb of the pixel defining layer 380 may be different due to process errors, etc., and can form an angle of 0 degrees or more and 20 degrees or less.

Although the opening is of the same color in the embodiment of FIG. 8, two or more oval shapes with different eccentricities may be placed in various positions at various proportions.

Depending on the embodiment, the same number of oval shapes with different eccentricities may be included in the display area, and depending on the embodiment, they may be included in different numbers.

As an example, when the red opening OPr of the pixel defining layer 380 has two elliptical shapes with different eccentricities, the corresponding red second opening OPBMr of the light blocking layer 220 can also have different eccentricities.

However, depending on the embodiment, the red second opening OPBMr of the light blocking layer 220 may be formed with the same eccentricity.

Referring to FIG. 8, the angle formed by each major axis of the plurality of openings OPr, OPg, OPb of the pixel defining layer 380 or the plurality of second openings OPBMr, OPBMg, OPBMb of the light blocking layer 220 is the first angle, and it forms an angle of 45 degrees with respect to the first direction DR1 and the second direction DR2.

In an embodiment in which the eccentricity of the ellipse is formed in various ways, unlike FIG. 7, the number of angles formed by the major axis of the ellipse may be four or less.

For example, in the embodiment of FIG. 8, various elliptical shapes with different eccentricities are formed to reduce color separation of external light or to generate a constant diffraction pattern or color separation regardless of angle.

Therefore, the embodiment of FIG. 8 enables constant color separation and/or constant diffraction in a different manner from the embodiment of FIG. 7 in which the major axis direction of the ellipse is varied.

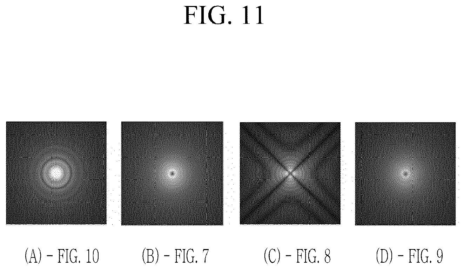

In the embodiment of FIG. 8, the number of ellipses in the major axis direction is small, so a reflection diffraction pattern as shown in FIG. 11, element (C) can be generated, so a plurality of openings OPr, OPg, OPb of the pixel defining layer 380 or the directionality of the diffraction pattern may be reduced by forming one of the plurality of second openings OPBMr, OPBMg, OPBMb of the light blocking layer 220 in a circular shape or by increasing the number of maj or axis directions in an elliptical shape.

The following will look at the embodiment of FIG. 9. The embodiment of FIG. 9 combines the embodiment of FIG. 7 and the embodiment of FIG. 8.

In FIG. 9, the second opening OPBMr, OPBMg, OPBMb of the light blocking layer 220 and the opening OPr, OPg, OPb of the pixel defining layer 380 have an elliptical shape with different eccentricities even for the same color, the angles formed by the major axes of the second opening OPBMr, OPBMg, OPBMb of the light blocking layer 220 and the opening OPr, OPg, OPb of the pixel defining layer 380 each have four or more angles, or the angles formed by the major axes are arranged at intervals of 45 degrees or less.

Here, referring to FIG. 16, the eccentricity of the oval shape may range from 0.2 to 0.85.

The embodiment of FIG. 9 includes all the features of the embodiment of FIG. 7 and the embodiment of FIG. 8, such that multiple openings OPr, OPg, OPb of the pixel defining layer 380 or multiple second openings OPBMr, OPBMg, OPBMb of the light blocking layer 220 have four or more angles, or are arranged at intervals of less than 45 degrees, and additionally, the eccentricity of the ellipse is variously formed to reduce the color separation of external light or to generate a constant diffraction pattern or color separation regardless of the angle.

Depending on the embodiment, the major axis directions of the plurality of openings OPr, OPg, OPb of the pixel defining layer 380 or the plurality of second openings OPBMr, OPBMg, OPBMb of the light blocking layer 220 are formed at equal intervals or irregular intervals.

A rough comparison of the embodiments of FIG. 7 to FIG. 9 is shown in Table 1 below.

**[Table 1]**

| item | FIG. 7 embodiment | FIG. 8 embodiment | FIG. 9 embodiment |
|---|---|---|---|
| eccentricity of the second opening ellipse of the color filter | red, green, blue same eccentricity | eccentricity 2 or more different eccentricity by color opening of the same color has a different eccentricity (a circle with an eccentricity of 0 is also possible) | eccentricity 2 or more different eccentricity by color opening of the same color has a different eccentricity (a circle with an eccentricity of 0 is also possible) |
| color filter second opening area (aperture ratio) | same | area varies depending on eccentricity | area varies depending on eccentricity |
| arrange ratio | equalization arranged | total number of ellipses with different eccentricities is the same or different | total number of ellipses with different eccentricities is the same or different |
| Pixel defining layer opening ellipse major axis angle | four or more angles | 2 angles of 45 degrees (angles less than 4 are also possible) | Can be arranged at 4 or more angles |
| second elliptical shape of the color filter's opening | pixel defining layer defined to be offset at a certain distance in the opening | pixel defining layer defined to be offset at a certain distance in the opening | pixel defining layer defined to be offset at a certain distance in the opening |

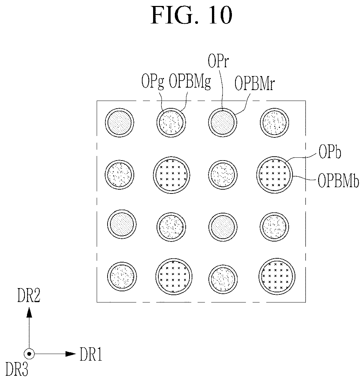

To examine the characteristics of the above-mentioned embodiment, the comparative example of FIG. 10 is examined, and the diffraction characteristics and color dispersion characteristics of reflected light between the comparative example and the example are compared and examined through FIG. 11.

FIG. 10 is a plan view of a portion of the display panel according to the comparative example, and FIG. 11 is a photograph of reflection characteristics of the comparative example and the examples of FIG. 7 to FIG. 9.

In the comparative example of FIG. 10, unlike the embodiments of FIG. 7 to FIG. 9, both the second opening OPBMr, OPBMg, OPBMb of the light blocking layer 220 and the opening OPr, OPg, OPb of the pixel defining layer 380 have a circular shape.

FIG. 11 shows the diffraction pattern and color dispersion of reflected light for the examples of FIG. 7 to FIG. 9 and the comparative example of FIG. 10, with FIG. 11, element (A) being the comparative example of FIG. 10 and FIG. 11, element (B) is the embodiment of FIG. 7, FIG. 11, element (C) is the embodiment of FIG. 8, and FIG. 11, element (D) is the embodiment of FIG. 9.

First, looking at the comparative example of FIG. 11, element (A), the diffraction pattern has a ring shape and is independent of the angle, but multiple rings are formed, each showing different colors, confirming that the reflected light is color-separated.

In contrast, referring to FIG. 11, element (B) and FIG. 11, element (D), the diffraction pattern has no directionality, so it has a diffraction pattern that is independent of the angle, and the ring shape is not recognized and appears white overall, so no specific color separation occurs.

In FIG. 11, element (C), the diffraction pattern has a linear pattern at an angle of 45 degrees, forming a diffraction pattern according to the angle. This is caused by arranging the major axis angle of the ellipse only at 45 degrees, so some of the openings are circular. The diffraction characteristics depending on the angle can be reduced by forming or increasing the direction of the major axis of the ellipse.

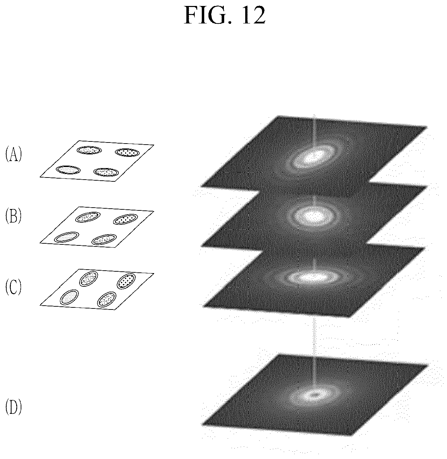

Below, the characteristics according to the major axis angle through FIG. 12 to FIG. 14 will be examined.

First, the relationship between the major axis angle of the ellipse and the direction of the diffraction pattern of reflected light through FIG. 12 will be examined.

FIG. 12 is a diagram showing reflection characteristics of a light emitting display device depending on the angle.

The left side of elements (A), (B), and (C) of FIG. 12 shows a structure in which the opening of the pixel defining layer 380 and the opening of the light blocking layer 220 are arranged in the same direction, and on the right side, the diffraction pattern of reflected light is shown.

Referring to FIG. 12, when the opening of the pixel defining layer 380 and the opening of the light blocking layer 220 have an elliptical shape, the diffraction pattern of the reflected light also has an elliptical shape, but it can be seen that the major axis directions are different.

For example, the major axis direction of the opening of the pixel defining layer 380 and the opening of the light blocking layer 220 and the major axis direction of the elliptical pattern of the diffraction pattern of the reflected light may be perpendicular to each other.

When the diffraction patterns (A), (B), and (C) on the right side of FIG. 12 are combined, it becomes a circular diffraction pattern as shown in FIG. 12, element (D) below, showing that it is possible to have a diffraction pattern that is independent of angle.

Hereinafter, through FIG. 13 and FIG. 14, it will examined to what extent elliptical structures arranged at various angles are needed to form a diffraction pattern independent of angle.

FIG. 13 is a diagram showing various angle arrangements according to an embodiment, and FIG. 14 is a photograph of reflection characteristics according to angle.

First, FIG. 13 shows the major axis directions of one set of ellipses that can be formed in one display area.

In FIG. 13, element (A), the opening OP of the pixel defining layer 380 or the second opening OPBM of the light blocking layer 220 has two major axis directions, the two major axes are spaced at an angle of 90 degrees, and an example in which directions are arranged is shown. In FIG. 13, element (B), the opening OP of the pixel defining layer 380 or the second opening OPBM of the light blocking layer 220 has four major axis directions, the four major axes are spaced at an angle of 45 degrees, and an example in which directions are arranged is shown.

In FIG. 13, element (C), the opening OP of the pixel defining layer 380 or the second opening OPBM of the light blocking layer 220 has nine major axis directions, with nine major axes at intervals of 20 degrees, and an example in which directions are arranged is shown.

In addition to the major axis direction shown in FIG. 13, it can be formed in various major axis directions arranged at various angles. If the number of maj or axis directions is small, differences in the diffraction pattern depending on the angle occur as shown in FIG. 11, element (C), and it may include a certain number or more of maj or axis angles.

To confirm this, FIG. 14 shows diffraction patterns according to the number of various major axis directions.

FIG. 14, element (A) is a diffraction pattern of an example with 4 major axis angles as in FIG. 13, element (B), FIG. 14, element (B) is a diffraction pattern of an example with 5 major axis angles, and FIG. 14, element (C) is a diffraction pattern of an example with 6 major axis angles. FIG. 14, element (D) is a diffraction pattern of an example with 7 major axis angles, and FIG. 14, element (E) is a diffraction pattern of an example with 8 major axis angles.

To have a diffraction pattern that is independent of the direction in FIG. 14, it is better to have a diffraction pattern close to a circular shape, and in FIG. 14, element (A), it can be seen that the diffraction characteristics and color separation are different depending on the direction due to the protruding shape.

However, compared to the comparative example of FIG. 11, element (A), the diffraction pattern is not clear and is not clearly visible compared to the comparative example.

FIG. 14, element (B) to FIG. 14, element (E) have circular diffraction patterns and have diffraction characteristics and color separation independent of direction.

Therefore, based on FIG. 14, if the opening OP of the pixel defining layer 380 or the second opening OPBM of the light blocking layer 220 is formed to have four or more major axis angles, constant diffraction occurs regardless of the angle, pattern or color separation may occur and display quality may be increased.

Referring to the above, it may have four or more major axis angles, and in an embodiment having four or more major axis angles, the major axis angles may be arranged at intervals of 45 degrees or less.

In the above, the angles and number of angles between the angles of the major axis of the oval were examined.

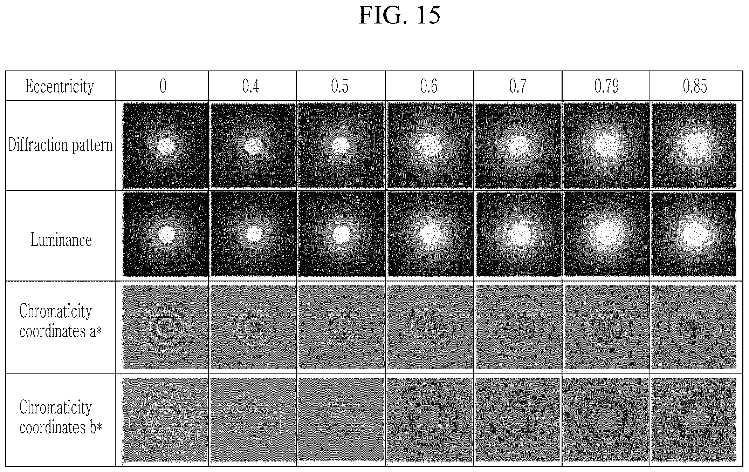

Below, based on FIG. 15 and FIG. 16, changes in reflection characteristics according to changes in the eccentricity of the ellipse will be examined.

FIG. 15 and FIG. 16 are diagrams showing reflection characteristics according to eccentricity.

FIG. 15 shows a diagram in which the luminance distribution and the dispersion on the two axes of color coordinates are extracted for the color diffraction pattern of reflected light according to the value of eccentricity. Based on this, FIG. 16 shows the standard deviation value of luminance based on the eccentricity. The distance values on color coordinates are shown in a graph.

In FIG. 15 and FIG. 16, the smaller the distance value on the luminance distribution and color coordinates, the weaker the diffraction is recognized.

In FIG. 16, the position where the distance value on the luminance scale or color coordinates is the smallest is indicated by an arrow.

Referring to FIG. 15 and FIG. 16, it can be seen that when the eccentricity is 0.5, it has the smallest luminance distribution value and is the best embodiment even considering color coordinate distribution.

Also, referring to FIG. 16, it is determined that in the area partitioned by the dotted line-for example, in the range of 0.2 to 0.85-the luminance scatter and color coordinate scatter do not significantly degrade the display quality, so an ellipse with such a range of eccentricity can be applied to this embodiment.

In the above, an embodiment in which the opening OP of the pixel defining layer 380 or the second opening OPBM of the light blocking layer 220 has one eccentricity was examined.

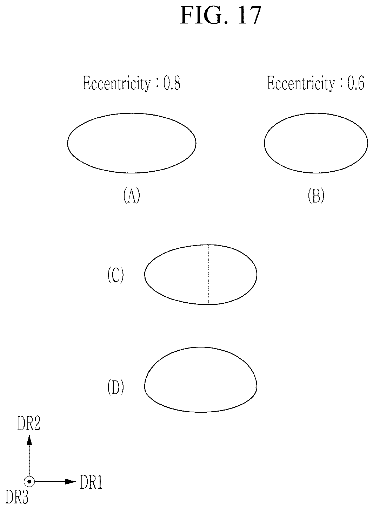

Depending on the embodiment, at least two elliptical shapes with different eccentricities may be merged to form an opening OP of one pixel defining layer 380 or a second opening OPBM of the light blocking layer 220. This will be examined in detail through FIG. 17 to FIG. 19.

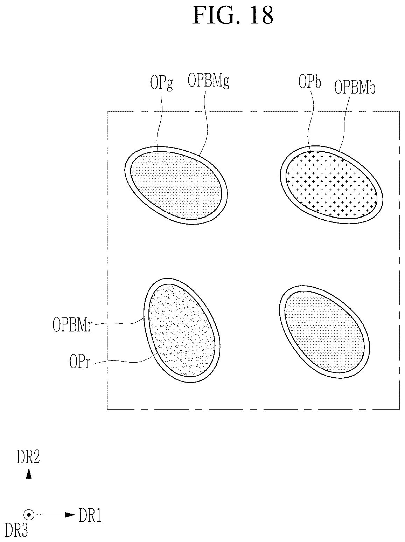

First, the basic oval shape and the arrangement of the openings based on it through FIG. 17 and FIG. 18 will be examined.

FIG. 17 and FIG. 18 are diagrams showing a structure combining ellipses with different eccentricities.

In FIG. 17, an example of merging two or more ellipse shapes with different eccentricities is shown in detail.

FIG. 17, element (A) and FIG. 17, element (B) depict ellipses with different eccentricities, and FIG. 17, element (C) and FIG. 17, element (D) depict ellipses combined in different ways, each with different eccentricities.

In FIG. 17, element (A), an ellipse with an eccentricity of 0.8 is shown, and in FIG. 17, element (B), an ellipse shape with an eccentricity of 0.6 is shown.

An ellipse that merges these two ellipses may have a shape like FIG. 17, element (C) or FIG. 17, element (D).

In FIG. 17, element (C) and FIG. 17, element (D), a dotted line is shown within the merged oval shape, and the ovals on both sides of the dotted line are parts of an ellipse with different eccentricities.

For example, FIG. 17, element (C) is an example of the ellipses of FIG. 17, element (A) and FIG. 17, element (B) cut along the second direction DR2 and then combined, and FIG. 17, element (D) is an example of FIG. 17, element (A) and FIG. 17, element (D). This is an example of cutting the ellipse in (B) along the first direction DR1 and then combining them.

The method of combining two ellipses with different eccentricities is not necessarily limited to this and can be combined in various ways.

An example is depicted in FIG. 18, where the second opening OPBMr, OPBMg, OPBMb of the light blocking layer 220 and the opening OPr, OPg, OPb of the pixel defining layer 380 are arranged in various major axis directions using an elliptical shape combined in the same way as in FIG. 17, element (C).

In the embodiment of FIG. 18, only one unit pixel is shown, and one unit pixel includes one red opening OPr, OPBMr, one blue opening OPb, OPBMb, and two green openings OPg, OPBMg.

In the embodiment of FIG. 18, the major axis direction of each opening OPr, OPg, OPb of the pixel defining layer 380 can be different from each other, and the major axis direction of each second opening OPBMr, OPBMg, OPBMb of the light blocking layer 220 can also be different from each other.

As shown in FIG. 14, the embodiment using an ellipse that is a combination of two ellipses with different eccentricities as shown in FIG. 18 also uses the openings OPr, OPg, OPb of the pixel defining layer 380 and the second opening of the light blocking layer 220, the angles formed by each major axis of the openings OPBMr, OPBMg, OPBMb may have four or more angles, and the angles formed by the major axes may be arranged at intervals of 45 degrees or less.

Additionally, the eccentricities of the two ellipses used for merging may vary, so the size of the merged ellipses may also vary.

Additionally, depending on the embodiment, two ovals with different eccentricities for each color can be combined, and even if they are the same color, two ovals with different eccentricities can be combined to form various ovals.

Here, the eccentricity of the openings OPr, OPg, OPb of the pixel defining layer 380 and/or the second openings OPBMr, OPBMg, OPBMb of the light blocking layer 220 can have an eccentricity of 0.2 to 0.85, as in FIG. 15 and FIG. 16.

The major axis direction of the opening OPr, OPg, OPb of the pixel defining layer 380 and the corresponding second opening OPBMr, OPBMg, OPBMb of the light blocking layer 220 can be the same or form an angle of 20 degrees or less due to process errors, etc.

The openings OPr, OPg, OPb of the pixel defining layer 380 and the corresponding second openings OPBMr, OPBMg, OPBMb of the light blocking layer 220 have a certain spacing in the plane or are spaced apart from each other by more than 0 µm and less than 20 µm, it may have the following horizontal spacing.

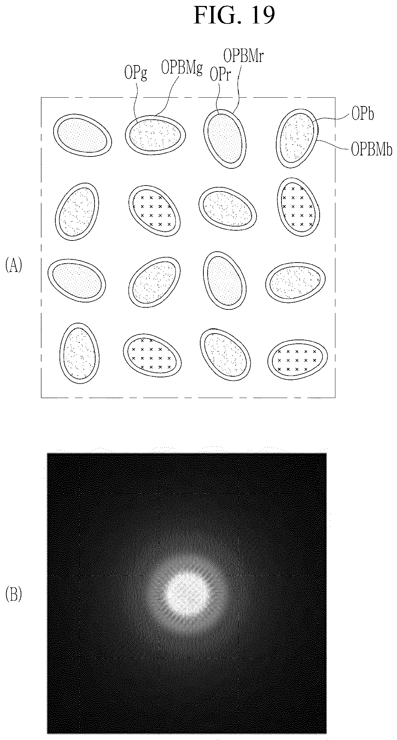

Below, the diffraction characteristics of reflected light for an example (FIG. 19, element (A)) using an elliptical shape merged in the same manner as in FIG. 17, element (C) is discussed.

FIG. 19 is a diagram showing a merged elliptical structure and its reflection characteristics according to an embodiment.

FIG. 19, element (A) shows an embodiment in which the openings of each color have the same merged elliptical shape, but the major axis direction has five or more angles.

In FIG. 19, element (B), the diffraction characteristics of the reflected light in FIG. 19, element (A) are shown.

Compared to the comparative example of FIG. 11, element (A), it can be seen that the diffraction characteristic of FIG. 19, element (B) has a blurred reflection diffraction pattern, the ring shape is less clear, and the separated colors are difficult for the user to easily recognize.

As a result, the example shown in FIG. 19, element (A) can also have increased display quality compared to the comparative example.

In the embodiments of FIG. 17 to FIG. 19, the illustration and description focus on the embodiment of merging two different oval shapes.

However, depending on the embodiment, it is also possible to merge two or more elliptical shapes with different eccentricities.

As described above, the embodiment of merging two or more oval shapes also has a reflection diffraction pattern with blurred diffraction characteristics similar to FIG. 19, element (B), the ring shape is less clear, and the separated colors are difficult for the user to easily recognize, so it can have increased display quality compared to the comparative example.

In addition, the elliptical shape of the openings OPr, OPg, OPb of the pixel defining layer 380 and the elliptical shape of the second openings OPBMr, OPBMg, OPBMb of the corresponding light blocking layer 220 are spaced at a constant distance in a plan view, or the spacing in a plan view may vary depending on the location.

For example, depending on the embodiment, the number or eccentricity of the elliptical shapes merging with the elliptical shapes of the openings OPr, OPg, OPb of the pixel defining layer 380 may be determined by the second opening of the light blocking layer 220, and the number or eccentricity of the elliptical shapes of OPBMr, OPBMg, OPBMb merging may be different.

As above, even when the elliptical shape of the opening OPr, OPg, OPb of the pixel defining layer 380 and the elliptical shape of the second opening OPBMr, OPBMg, OPBMb of the light blocking layer 220 corresponding to this are different, it can have a diffraction pattern with diffused diffraction characteristics similar to FIG. 19, element (B), making the ring shape less clear, and making it difficult for the user to easily recognize the color separation, thereby having an increased display quality compared to the comparative example.

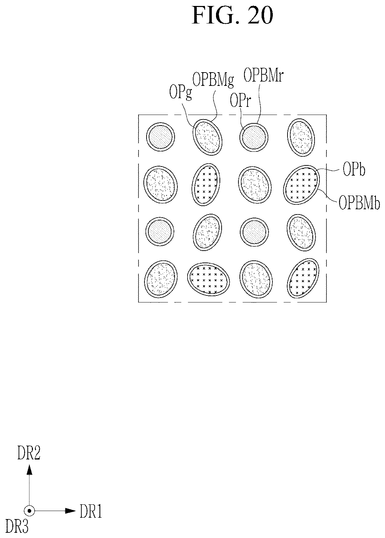

Depending on the embodiment, the openings of some colors may have a circular shape rather than an oval, and this embodiment will be examined with reference to FIG. 20.

FIG. 20 is a plan view of a portion of a display panel according to an embodiment.

FIG. 20 is based on the embodiment of FIG. 9, and differs from FIG. 9 in that the red opening OPr of the pixel defining layer 380 and the red second opening OPBMr of the light blocking layer 220 are not elliptical but circular.

For example, the green opening OPg and blue opening OPb of the pixel defining layer 380 and the green second openings OPBMg and the blue second openings OPBMb of the light blocking layer 220 are all oval shaped.

Depending on the embodiment, one color in addition to red among the three-color openings may have a circular shape.

According to the embodiment, one or two of the red opening OPr, green opening OPg, and blue opening OPb of the pixel defining layer 380 can have a circular shape, and the rest can have an elliptical shape.

In addition, the red second opening OPBMr, the green second opening OPBMg, and the blue second opening OPBMb of the light blocking layer 220 have shapes corresponding to the respective plane shapes of the red openings OPr, green opening OPg, and blue opening OPb of the corresponding pixel defining layer 380, and may respectively have a certain horizontal distance from the red openings OPr, green opening OPg, and blue opening OPb of the corresponding pixel defining layer 380.

At this time, when the openings OPr, OPg, OPb of the pixel defining layer 380 have an oval shape, the second openings OPBMr, OPBMg, OPBMb of the corresponding light blocking layer 220 also have an oval shape, the corresponding openings OPr, OPg, OPb of the pixel defining layer 380 and the second openings OPBMr, OPBMg, OPBMb of the light blocking layer 220 may have the same oval shape and have the same major axis direction.

As in the embodiment of FIG. 9, in the embodiment of FIG. 20, among the second openings OPBMr, OPBMg, OPBMb of the light blocking layer 220 and the openings OPr, OPg, OPb of the pixel defining layer 380, openings having oval shapes may have oval shapes with different eccentricities even for the same color, and may be arranged at intervals where the angle formed by each major axis has four or more angles or the angle formed by the major axis is less than 45 degrees.

Here, the eccentricity of the oval shape may range from 0.2 to 0.85.

Depending on the embodiment, the oval-shaped major axes of the plurality of openings OPr, OPg, OPb of the pixel defining layer 380 or the plurality of second openings OPBMr, OPBMg, OPBMb of the light blocking layer 220 are equally spaced, and may be formed at regular intervals or at irregular intervals.

In FIG. 20, at least one pair of the plurality of openings OPr, OPg, OPb of the pixel defining layer 380 and the plurality of second openings OPBMr, OPBMg, OPBMb of the light blocking layer 220 has an oval shape.

As a result, as described above, it can have less color separation of external light or a constant diffraction pattern or color separation regardless of angle.

The embodiment of FIG. 20 is an embodiment in which the oval shape for one or two colors of the embodiment of FIG. 9 is changed to a circle shape, but in the embodiment of FIG. 7 or FIG. 8, the oval shape is changed to a circle shape for one or two colors, and the shape can be changed to a circle shape.

In addition, in the embodiments of FIG. 18 and FIG. 19, the oval shape can be changed to a circle shape for one or two colors.

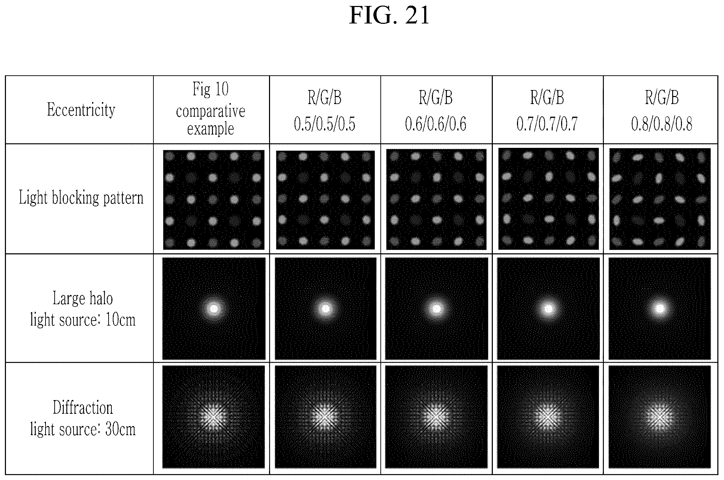

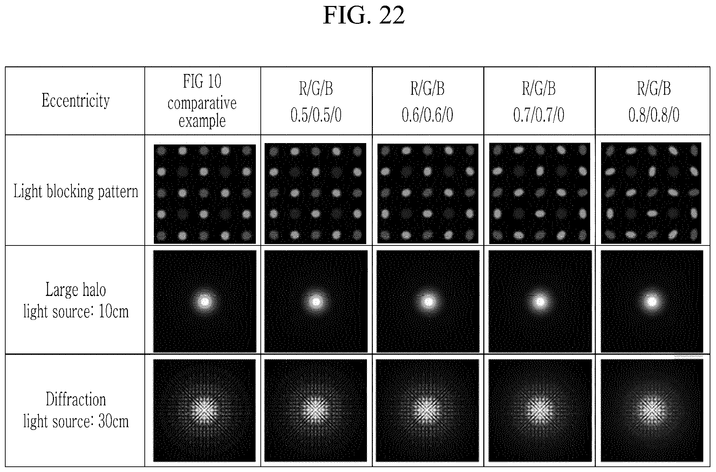

Hereinafter, reflection characteristics according to eccentricity for various embodiments will be examined through FIG. 21 and FIG. 22.

FIG. 21 and FIG. 22 are diagrams showing reflection characteristics according to eccentricity.

First, FIG. 21 shows reflection characteristics while changing the eccentricity in a display device having the same eccentricity as in FIG. 7.

The eccentricity values described in FIG. 21 are values of the plurality of second openings OPBMr, OPBMg, OPBMb of the light blocking layer 220.

In FIG. 21, two pictures are included. One is a picture taken with external light provided at 10 cm, and the other is a picture taken with external light provided at 30 cm.

Here, the photo taken at 10 cm shows the size and intensity of the halo that occurs around strong light, and the photo taken at 30 cm shows the characteristic of external light being reflected and diffracted.

Referring to FIG. 21, in the comparative example of FIG. 10, a halo, a ring-shaped pattern, is strongly visible as external light is reflected, but in the example using an ellipse, the eccentricity is 0.5, 0.6, 0.7, and 0.8, and the ring-shaped halo is not visible.

FIG. 22 shows reflection characteristics in an embodiment in which one color has a circular shape rather than an oval shape and the other two colors have an oval shape, as in FIG. 20.

In FIG. 22, unlike FIG. 20, blue has a circular shape, and for example, the blue opening OPb of the pixel defining layer 380 and the blue second opening OPBMb of the light blocking layer 220 have a circular shape and the remaining openings have an oval shape.

At this time, FIG. 22 shows the reflection characteristics while changing the eccentricity of the oval-shaped opening.

The eccentricity values described in FIG. 22 are values of the plurality of second openings OPBMr, OPBMg, OPBMb of the light blocking layer 220, and 0 represents a circular shape.

Referring to FIG. 22, in the comparative example of FIG. 10, the halo, which is a ring-shaped pattern, is strongly visible as external light is reflected, but in the example including at least one oval, the halo is not visible.

Also, since no halo is recognized in the pictures of FIG. 22 corresponding to the embodiment of FIG. 20 and the pictures of the embodiment of FIG. 7 shown in FIG. 21, it can be confirmed that the embodiment of FIG. 20 has an effect equivalent to the embodiment of FIG. 7.

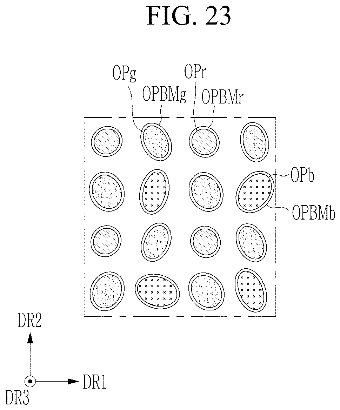

Hereinafter, another modified embodiment will be looked at through FIG. 23 to FIG. 25.

FIG. 23 to FIG. 25 are plan views of a portion of a display panel according to an embodiment.

First, the embodiment of FIG. 23 will be examined.

Referring to FIG. 20 and FIG. 22, it was confirmed that the embodiment in which one or two colors have an oval shape and the remaining colors have a circle shape had an effect similar to the embodiment in which all colors have an oval shape.

Therefore, depending on the embodiment, an oval shape is used instead of a circle shape, and it can be seen that a similar effect can be achieved even with an eccentricity (more than 0 and less than 0.2) other than the eccentricity (0.2 to 0.85) defined above.

One of these embodiments will be examined through FIG. 23.

FIG. 23 is a modified example of FIG. 20, in which the two red openings OPr, OPBMr in FIG. 20 are transformed into ellipses with an eccentricity of more than 0 and less than 0.2 instead of circular shapes.

For example, the embodiment of FIG. 23 is based on the embodiment of FIG. 9, and the red opening OPr of the pixel defining layer 380 and the red second opening OPBMr of the light blocking layer 220 exceed 0 and are less than 0.2, andit differs from FIG. 9 and FIG. 20 in that it has an elliptical shape with an eccentricity of less than 20 degrees.

For example, the green opening OPg and blue opening OPb of the pixel defining layer 380 and the green second opening OPBMg and blue second opening OPBMb of the light blocking layer 220 are all 0.2 or more. It has an oval shape with an eccentricity of less than 0.85.

Depending on the embodiment, one additional color in addition to red among the three-color openings may have an oval shape with an eccentricity of more than 0 and less than 0.2. For example, depending on the embodiment, one or both of the red opening OPr, green opening OPg, and blue opening OPb of the pixel defining layer 380 have an elliptical shape with an eccentricity of more than 0 and less than 0.2, and the remainder may have an elliptical shape with an eccentricity of 0.2 or more and 0.85 or less.

In addition, the red second opening OPBMr, the green second opening OPBMg, and the blue second opening OPBMb of the light blocking layer 220 may have shapes corresponding to the respective plane shapes of the red opening OPr and green opening OPg of the pixel defining layer 380, and may have a certain horizontal distance from the red opening OPr, the green opening OPg, and blue opening OPb of the pixel defining layer 380.

At this time, the openings OPr, OPg, OPb of the pixel defining layer 380 and the corresponding second openings OPBMr, OPBMg, OPBMb of the light blocking layer 220 may have the same oval-shaped major axis direction.

In FIG. 23, as in the embodiment of FIG. 9, the second openings OPBMr, OPBMg, OPBMb of the light blocking layer 220 and the openings OPr, OPg, OPb of the pixel defining layer 380 are of the same color, they also have oval shapes with different eccentricities, and the second openings OPBMr, OPBMg, OPBMb of the light blocking layer 220 and the openings OPr, OPg, OPb of the pixel defining layer 380 are formed by their respective major axes, the angle may have four or more angles or the angle formed by the major axis may be arranged at intervals of less than 45 degrees.

Depending on the embodiment, the oval-shaped major axes of the plurality of openings OPr, OPg, OPb of the pixel defining layer 380 or the plurality of second openings OPBMr, OPBMg, OPBMb of the light blocking layer 220 are equally spaced, and may be formed at equal intervals or at irregular intervals.

In the embodiment of FIG. 23, at least one pair of the plurality of openings OPr, OPg, OPb of the pixel defining layer 380 and the plurality of second openings OPBMr, OPBMg, OPBMb of the light blocking layer 220 has an oval shape with an eccentricity of 0.2 or more than 0.85.

As a result, as described above, it can have less color separation of external light or a constant diffraction pattern or color separation regardless of angle.

The embodiment of FIG. 23 is an embodiment in which the oval shape for one or two colors of the embodiment of FIG. 9 is changed to an oval shape with an eccentricity of more than 0 and less than 0.2, but alternatively, in the embodiment of FIG. 7 or FIG. 8, the oval shape can be changed to an oval shape with an eccentricity between 0 and less than 0.2 there is also one, for one or two colors.

In addition, in the embodiments of FIG. 18 and FIG. 19, the elliptical shape for one or two colors can be changed to an elliptical shape with an eccentricity of more than 0 and less than 0.2.

The above focuses on an embodiment in which the openings OPr, OPg, OPb of the pixel defining layer 380 and the corresponding second openings OPBMr, OPBMg, OPBMb of the light blocking layer 220 are spaced at regular intervals in a plan view.

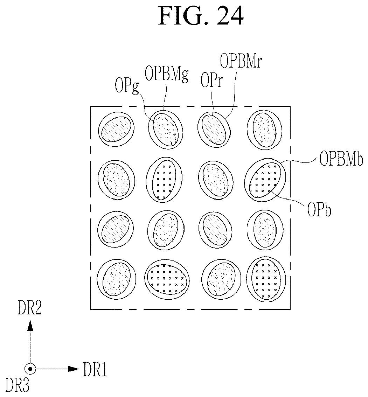

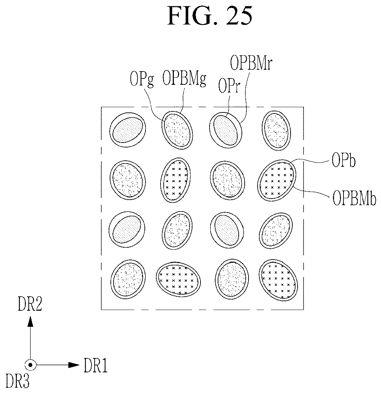

However, depending on the embodiment, the horizontal gap between the openings OPr, OPg, OPb of the pixel defining layer 380 and the corresponding second openings OPBMr, OPBMg, OPBMb of the light blocking layer 220 may change depending on the position, and this embodiment will be examined through FIG. 24 and FIG. 25.

Here, the horizontal gap between the openings OPr, OPg, OPb of the pixel defining layer 380 and the corresponding second openings OPBMr, OPBMg, OPBMb of the light blocking layer 220 may be greater than 0 µm and less than or equal to 20 µm.

First, let's look at the embodiment of FIG. 24.

In FIG. 24, an embodiment that the second openings OPBMr, OPBMg, OPBMb of the light blocking layers 220 and the corresponding openings OPr, OPg, OPb of the pixel defining layer 380 have different eccentricities is shown.

In the embodiment of FIG. 24, the eccentricity of the second opening OPBMr, OPBMg, OPBMb of the light blocking layer 220 can have a smaller value compared to the eccentricity of the opening OPr, OPg, OPb of the pixel defining layer 380 corresponding thereto.

However, according to the embodiment, the eccentricity of the opening OPr, OPg, OPb of the pixel defining layer 380 may have a smaller value compared to the eccentricity of the second opening OPBMr, OPBMg, OPBMb of the corresponding light blocking layer 220.

Referring to FIG. 24, the horizontal spacing between the openings OPr, OPg, OPb of the pixel defining layer 380 and the corresponding second openings OPBMr, OPBMg, OPBMb of the light blocking layer 220 is not constant, and it can be seen that there are wide and narrow positions.

In the embodiment of FIG. 24, the corresponding openings OPr, OPg, OPb of the pixel defining layer 380 and the second openings OPBMr, OPBMg, OPBMb of the light blocking layer 220 have the same oval-shaped major axis direction.

As shown in FIG. 24, even if the horizontal interval between the openings OPr, OPg, OPb of the pixel defining layer 380 and the second openings OPBMr, OPBMg, OPBMb of the corresponding light blocking layer 220 is not constant, as described above, due to various directions or various eccentricities, color separation of external light occurs less or a constant diffraction pattern or color separation occurs regardless of angle.

Additionally, even if external light is reflected, the halo, which is a ring-shaped pattern, might not be visible.

In FIG. 24, as in the embodiment of FIG. 9, the second openings OPBMr, OPBMg, OPBMb of the light blocking layer 220 and the openings OPr, OPg, OPb of the pixel defining layer 380 are of the same color, they may also have oval shapes with different eccentricities, and the second openings OPBMr, OPBMg, OPBMb of the light blocking layer 220 and the openings OPr, OPg, OPb of the pixel defining layer 380 have respective major axes, the angles formed may have four or more angles, or the angles formed by the major axis may be arranged at intervals of 45 degrees or less.

Here, the eccentricity of the oval shape may range from 0.2 to 0.85.

Depending on the embodiment, the oval-shaped major axes of the plurality of openings OPr, OPg, OPb of the pixel defining layer 380 or the plurality of second openings OPBMr, OPBMg, OPBMb of the light blocking layer 220 are equally spaced, and it may be formed at equal intervals or at irregular intervals.

Depending on the embodiment, the part where the horizontal spacing is not constant, as shown in FIG. 24, may be applied to only one or two colors.

This embodiment will be examined through FIG. 25.

The embodiment of FIG. 25 is based on the embodiment of FIG. 24, and only the red opening OPr of the pixel defining layer 380 and the red second opening OPBMr of the light blocking layer 220 have irregular horizontal intervals. It has a structure wherein the green opening OPg and the blue opening OPb of the pixel defining layer 380 and the green second opening OPBMg and the blue second opening OPBMb of the light blocking layer 220 are horizontal, and it has a structure with constant spacing.

Depending on the embodiment, one color in addition to red among the three-color openings may have a shape with uneven horizontal spacing.

For example, depending on the embodiment, one or two of the red opening OPr, the green opening OPg, and the blue opening OPb of the pixel defining layer 380 may cause the red opening of the corresponding light blocking layer 220 to have a shape in which the horizontal spacing between the red second opening OPBMr, the green second opening OPBMg, and the blue second opening OPBMb is not constant.

In the embodiment of FIG. 25, at least one pair among multiple openings OPr, OPg, OPb of the pixel defining layer 380 and multiple second openings OPBMr, OPBMg, OPBMb of the light blocking layer 220 has a shape with constant horizontal spacing.

As a result, as described above, it can have less color separation of external light or a constant diffraction pattern or color separation regardless of angle.

Additionally, even if external light is reflected, the halo, which is a ring-shaped pattern, might not be visible.

The embodiments of FIG. 24 and FIG. 25 are modified embodiments based on the embodiments of FIG. 9, but can be modified so that the horizontal spacing is not constant even based on the embodiments of FIG. 7 and FIG. 8.

In addition, in the embodiments of FIG. 18 and FIG. 19, the horizontal spacing can be changed to be non-constant.

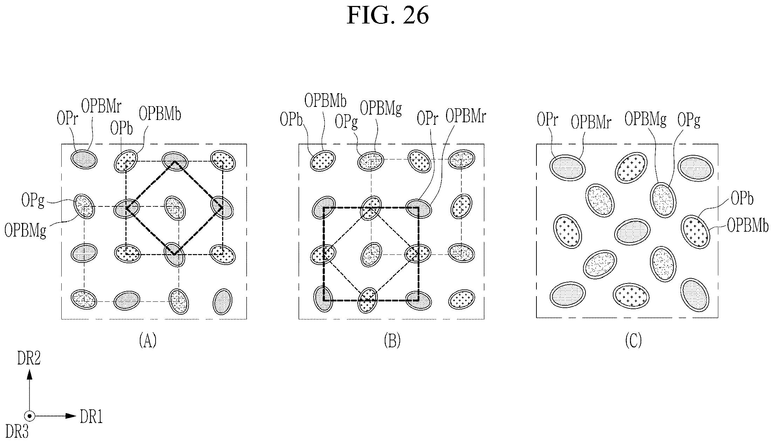

Below, the structure of one unit pixel with another arrangement through FIG. 26 will be examined.

FIG. 26 is a plan view showing the configuration of a unit pixel of one of the display panels according to an embodiment.

First, FIG. 26, element (A) and FIG. 26, element (B) are modified examples of FIG. 7 described above, and, unlike FIG. 7, show an example having unit pixels divided into different colors.

In FIG. 26, element (A), a unit pixel divided into red is shown, and it is an embodiment that includes two red-light emitting areas among the four adjacent light emitting areas, and each includes one green-light emitting area and one blue-light emitting area.

Additionally, in FIG. 26, element (A), four adjacent red-light emitting areas have a diamond shape, and four adjacent green- and blue-light emitting areas respectively have a rectangular shape.

In FIG. 26, element (B), a unit pixel divided into blue is shown, and it is an embodiment that includes two blue-light emitting areas among the four adjacent light emitting areas, and includes one red-light emitting area and one green-light emitting area each.

Additionally, in FIG. 26, element (B), four adjacent blue-light emitting areas have a diamond shape, and four adjacent red- and green-light emitting areas respectively have a rectangular shape.

FIG. 26, element (C) shows an embodiment having a different pixel arrangement from FIG. 7, 26, element (A) and FIG. 26, element (B).

Referring to FIG. 26, element (C), a second row containing only green-light emitting areas is disposed between the first row containing red- and blue-light emitting areas.

Additionally, in the first row, red-light emitting areas and blue-light emitting areas are alternately arranged in a repetitive manner.

The green-light emitting area may be located on a diagonal line connecting the red-light emitting area and/or the blue-light emitting area.

One light emitting area described in FIG. 26 corresponds to one opening OP of the pixel defining layer 380 and one second opening OPBM of the light blocking layer 220.

In the embodiment of FIG. 26, it is shown as having an elliptical structure as in FIG. 7, but depending on the embodiment, it may be modified to various embodiments mentioned in the present application.

As an example, in the arrangement of the light emitting areas of FIG. 26, element (C), the opening OP of the pixel defining layer 380 corresponding to each color of the light emitting area and the second opening OPBM of the light blocking layer 220 can each change the direction of the major axis as in FIG. 7, or the eccentricity of the ellipse can be changed as in FIG. 8.

In addition, the modified structure described above or the modified structure described later can be applied in various ways.

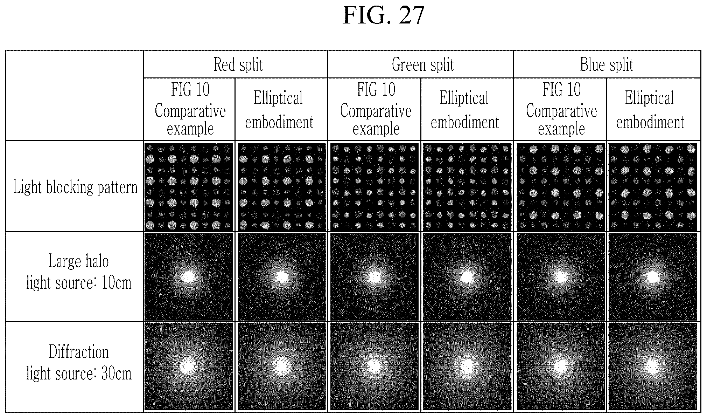

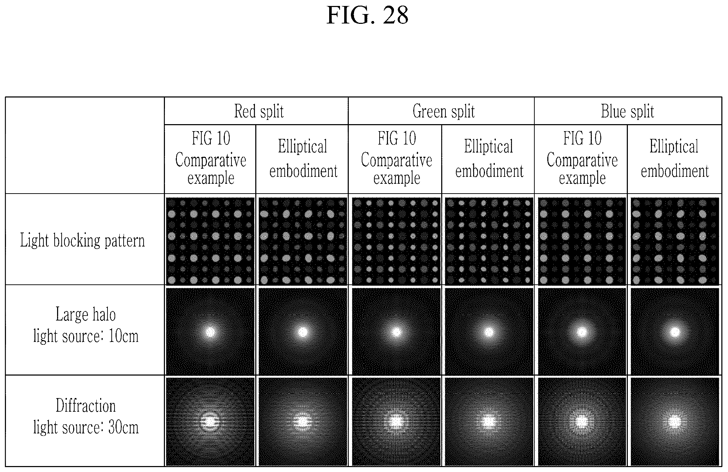

Hereinafter, through FIG. 27 and FIG. 28, the reflection characteristics of unit pixels divided into green, red, and blue will be compared with the comparative example.

FIG. 27 and FIG. 28 are diagrams showing the effect of pixel arrangement.

Firstly, in FIG. 27, it illustrates the reflective characteristics of the unit pixels divided into green from FIG. 7, the unit pixels divided into red from FIG. 26, element (A), and the unit pixels divided from blue from FIG. 26, element (B), in comparison with the comparative example in FIG. 10.

Referring to FIG. 27, it can be seen that all of the unit pixels divided into red/green/blue refrain from having a ring-shaped halo visible compared to the comparative example of FIG. 10.

In particular, by referring to the diffraction pattern taken by providing external light from FIG. 27 to 30cm, multiple ring patterns can be seen in the comparative example, but it can be confirmed that such ring patterns are not formed in each example, thus possessing reduced reflection of external light.

FIG. 28 shows an example in which unit pixels are divided in a different manner from FIG. 27.

In the divided unit pixels of FIG. 27, the divided color light emitting areas have a diamond shape as shown in FIG. 7, but in FIG. 28, the divided color light emitting areas of the divided unit pixels are oriented in one direction, as shown in FIG. 26, element (C), they are arranged continuously in one direction (e.g., the column direction).

Referring to FIG. 28, when comparing the divided unit pixels of each color with the comparative example of FIG. 10, it can be seen that the ring pattern generated in the comparative example is not visible in the embodiment, thereby having reduced reflection of external light.

In the above, the focus was on an embodiment in which the opening OP of the pixel defining layer 380 and the second opening OPBM of the light blocking layer 220 each have an oval or oval-like shape.

However, depending on the embodiment, only one of the opening OP of the pixel defining layer 380 and the second opening OPBM of the light blocking layer 220 may have an oval or oval-like shape, and the other may have a circular shape, and embodiments related to this will be examined below.

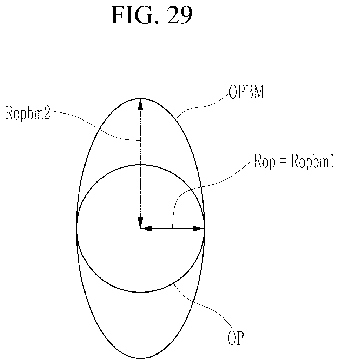

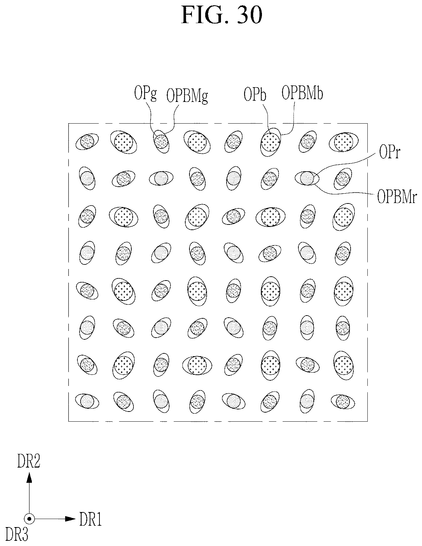

First, through FIG. 29 and FIG. 30, the second opening OPBM of the light blocking layer 220 has an oval shape, the opening OP of the pixel defining layer 380 has a circular shape, and the second opening OPBM of the light blocking layer 220 has a circular shape, an embodiment where the second opening OPBM and the opening OP of the pixel defining layer 380 are in contact will be examined.

FIG. 29 and FIG. 30 are plan views of a portion of a display panel according to an embodiment.

In FIG. 29, only the opening OP of one pixel defining layer and the second opening OPBM of the light blocking layer 220 corresponding thereto are shown.

In FIG. 29, the pixel defining layer is located on the outer portion of the opening OP, and the light blocking layer 220 is also located on the outer portion of the second opening OPBM.

In the embodiment of FIG. 29, the opening OP of the pixel defining layer 380 has a circular planar shape, and the second opening OPBM of the light blocking layer 220 has an elliptical planar shape.

The oval-shaped second opening OPBM of the light blocking layer 220 has a structure that contacts the circular opening OP of the pixel defining layer 380 at two points.

In the embodiment of FIG. 29, the radius value (Rop) of the circular shape of the opening OP of the pixel defining layer 380 is half the minor axis length of the elliptical shape of the second opening OPBM of the light blocking layer 220, it is the same as (Ropbm1), and it is less than half the length of the oval-shaped major axis (Ropbm2).

The half value (Ropbm2) of the major axis length of the elliptical shape may be greater than 0 µm and 20 µm or less than the radius value (Rop) of the circular shape of the opening OP of the pixel defining layer 380, and depending on the embodiment, it can be as large as 4.5 µm or more and 10 µm or less.

The length of the major axis of the ellipse can change the horizontal spacing depending on the thickness of the layer (for example, an encapsulation layer) located between the light blocking layer 220 and the pixel defining layer 380, and the encapsulation layer can have a thickness of about 6 µm.

Here, the ellipse has two foci, can have a shape connecting points where the sum of the distances to the two foci is constant, and can have a major axis and a minor axis.

The eccentricity of an ellipse is the distance between two foci divided by the length of the major axis.

When the eccentricity is 0, it is a circle, and when it is 1, it forms a parabola, so an ellipse has an eccentricity value that is greater than 0 and less than 1.

The eccentricity value of the oval shape of the second opening OPBM of the light blocking layer 220 may vary depending on the embodiment.

The direction of the major axis of the second opening OPBM of the light blocking layer 220 may also vary.

In the embodiment of FIG. 29, the opening OP of the pixel defining layer 380 and the second opening OPBM of the light blocking layer 220 contact at two points in a plan view, but due to errors during actual processing, the pixel defining layer a portion of one side of the opening OP of the pixel defining layer 380 may be covered with the light blocking layer 220 without overlapping the second opening OPBM of the light blocking layer 220.

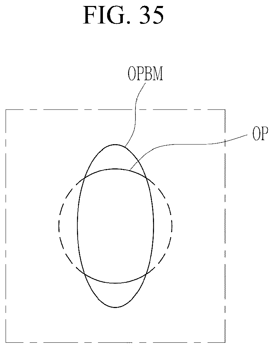

In this case, it can have a similar effect as the embodiment of FIG. 35 described later.

The opening OP of the pixel defining layer 380 and the second opening OPBM of the light blocking layer 220, which have the same structure as shown in FIG. 29, may be arranged as shown in FIG. 30 in the display area.

In FIG. 30, the opening OP of the pixel defining layer 380 and the second opening OPBM of the light blocking layer 220 corresponding to each light emitting layer are opened based on the light emitting layer displaying the three primary colors of red, green, and blue, respectively OPr, OPg, OPb and the second opening OPBMr, OPBMg, OPBMb.

Here, r, g, and b may correspond to red, green, and blue, respectively.

The second openings OPBMr, OPBMg, OPBMb of the light blocking layer 220 may be arranged at various angles, and the red second opening OPBMr, the green second opening OPBMg, and the blue second opening OPBMb of the color filter may be arranged at various angles. The blue second opening OPBMb can have different eccentricities.

Each of the second openings OPBMr, OPBMg, OPBMb of the same color may be formed with the same or a different eccentricity.

Here, the eccentricity of the oval shape may range from 0.2 to 0.85.

At this time, the red opening OPr, green opening OPg, and blue opening OPb of the pixel defining layer 380 may be formed as circles with different radii, and the same color opening OPr, OPg, OPb can each have the same or different radii.

The openings OPr, OPg, OPb of one pixel defining layer 380 correspond to the second openings OPBMr, OPBMg, OPBMb of one light blocking layer 220.

For example, within each of the second openings OPBMr, OPBMg, OPBMb of the light blocking layer 220, there is an opening OPr, OPg, OPb of the pixel defining layer 380 corresponding to each of the second openings OPBMr, OPBMg, OPBMb of the light blocking layer 220.

The corresponding second openings OPBMr, OPBMg, OPBMb of the light blocking layer 220 and the corresponding openings OPr, OPg, OPb of the pixel defining layer 380 may overlap each other in a plan view.

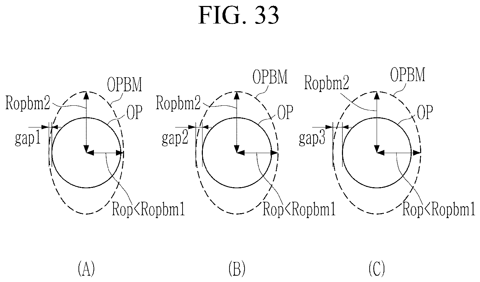

In the embodiment of FIG. 29, the circular openings OPr, OPg, OPb of the pixel defining layer 380 and the oval-shaped second openings OPBMr, OPBMg, OPBMb of the light blocking layer 220 contact each other at two points in a plan view. However, depending on the embodiment, the second openings OPBMr, OPBMg, OPBMb of the light blocking layer 220 are large, so that the circular openings OPr, OPg, OPb of the pixel defining layer 380 is formed within the second openings OPBMr, OPBMg, OPBMb of the light blocking layer 220 on a planar view (see FIG. 33), or the second openings OPBMr, OPBMg, OPBMb of the light blocking layer 220 are relatively small, so that the planar light blocking layer 220 may cover some of the circular openings OPr, OPg, OPb of the pixel defining layer 380 (see FIG. 35).

In FIG. 30, the second opening OPBMr, OPBMg, OPBMb of the light blocking layer 220 is arranged in various directions, and the angles at which each of the second openings OPBMr, OPBMg, OPBMb is arranged can be described based on the direction of the major axis of the ellipse.

Depending on the embodiment, the angles formed by each major axis of the second openings OPBMr, OPBMg, OPBMb of the light blocking layer 220 may have more than 4 different angles, and the angles formed by the major axis may be at intervals of 45 degrees or less.

As an example, looking at specific angle relationships focusing on an embodiment with five angles, the relationship is as follows.

An embodiment with five angles is formed with an interval of 36 degrees for each major axis, and in case one major axis has 0 degrees based on the first direction DR1, it has angles of 36 degrees, 72 degrees, 108 degrees, and 144 degrees, for a total of five angles.

The distance between the angles of the major axis can be checked by dividing the angle of 180 degrees by 5, which is the number of directions. This is because the two angles with an angle of 180 degrees out of 360 degrees have substantially the same direction of the major axis of the ellipse, which may mean calculating by dividing by the number based on 180 degrees. The plurality of second openings OPBMr, OPBMg, OPBMb of the color filter may be arranged at equal intervals at a specific angle of 45 degrees or less.

However, depending on the embodiment, the angle formed by the major axis of each second opening OPBMr, OPBMg, OPBMb may be one of 45 degrees or less and may be arranged at irregular intervals.

The embodiment in which the major axes of the openings are arranged at irregular intervals may be intentionally arranged to reduce the diffraction pattern, or may be arranged at irregular intervals due to processing errors.

In order to make the unit pixel containing the openings of red, green, and blue have a square structure, it may be appropriate to form them by distinguishing the number corresponding to the square of an integer for the angle of the major axis-for example, 2², 3², 4², 5², etc.

Here, the unit pixel may include one each of red, green, and blue openings, and a plurality of openings of one color-for example, green openings-may be formed.

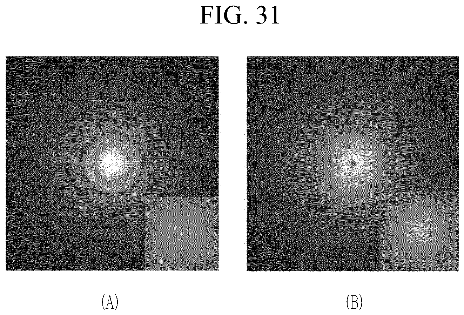

In this way, FIG. 31 examines the openings OPr, OPg, OPb of the pixel defining layer 380 having a circular shape, and the reflection characteristics when the second openings OPBMr, OPBMg, OPBMb of the light blocking layer 220 have an elliptical shape are observed.

FIG. 31 is a photograph of the reflection characteristics of the comparative example and the example of FIG. 30.

FIG. 31, element (A) shows the diffraction pattern and color dispersion of reflected light for the comparative example, and FIG. 31, element (B) shows the diffraction pattern and color dispersion of reflected light for the example of FIG. 30.

Here, in the comparative example, as shown in FIG. 10, the openings OPr, OPg, OPb of the pixel defining layer 380 and the second openings OPBMr, OPBMg, OPBMb of the light blocking layer 220 are all circular.

First, looking at the comparative example of FIG. 31, element (A), the diffraction pattern has a plurality of ring shapes. Each ring shape can be clearly seen, and each ring represents a different color, so the user can see that the reflected light is color separated.

In contrast, referring to FIG. 31, element (B), it can be seen that the diffraction pattern is relatively unclear and the shape of the ring is not clear.

This lack of clarity in the diffraction pattern may occur for the following reasons.

First, if the openings OPr, OPg, OPb of the pixel defining layer 380 have a circular shape, and the second opening OPBMr, OPBMg, OPBMb of the light blocking layer 220 have an elliptical shape, the distance between the two openings might not be constant. As a result, the diffraction pattern caused by the light emitted from the light emitting layer located within the opening OPr, OPg, OPb of the pixel defining layer 380 being refracted at the sidewalls of the second opening OPBMr, OPBMg, OPBMb of the light blocking layer 220 may vary. Therefore, when diffraction patterns are mixed, less constructive interference occurs and the diffraction patterns are blurred. Therefore, according to the elliptical second openings OPBMr, OPBMg, OPBMb of the light blocking layer 220, the diffraction pattern spreads and does not become clear. In addition, referring to FIG. 30, since the elliptical second openings OPBMr, OPBMg, OPBMb of the light blocking layer 220 are arranged at various angles, the directions of the diffraction patterns vary, resulting in blurry formation by mixing with each other, and a scattering effect appears.

Due to this mixing of diffraction patterns, the diffraction pattern is not clear and it is difficult for the user to see the diffraction pattern, thereby reducing the extent to which display quality is degraded.

Depending on the embodiment, the major axes of the elliptical second openings OPBMr, OPBMg, OPBMb of the light blocking layer 220 may be arranged at four or more angles or may be arranged at intervals of 45 degrees or less, and in this case, a lowered diffraction pattern and color separation may occur.

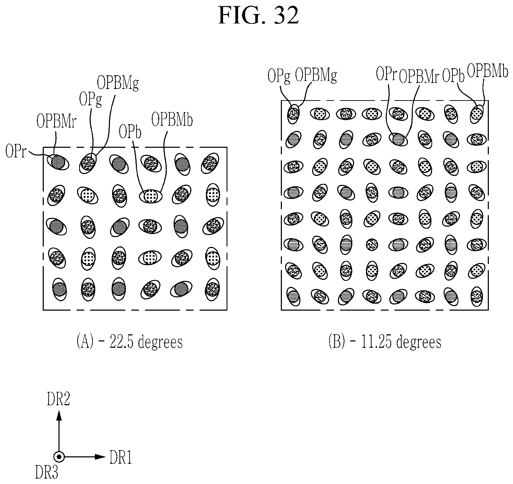

Hereinafter, through FIG. 32, two embodiments having a specific angular gap formed by the major axes of the elliptical second openings OPBMr, OPBMg, OPBMb of the light blocking layer 220 in the embodiment shown in FIG. 29 will be examined.

FIG. 32 is a plan view of a portion of the display panel in the embodiment of FIG. 29 arranged at various angles.

First, FIG. 32, element (A) shows an embodiment in which the major axes of the oval-shaped second openings OPBMr, OPBMg, OPBMb of the light blocking layer 220 are arranged at an angular interval of 22.5 degrees.

FIG. 32, element (B) shows an embodiment in which the major axes of the second openings OPBMr, OPBMg, OPBMb of the light blocking layer 220 are arranged at an angular interval of half that of FIG. 32, element (A)-for example, 11.25 degrees.

Here, in the embodiment of FIG. 32, element (A) with an angular spacing of 22.5 degrees, the number of angles formed by the major axes of the second openings OPBMr, OPBMg, OPBMb of the light blocking layer 220 having an elliptical shape can be 8.

For example, since 180 degrees divided by 8 is 22.5 degrees, the major axes of the second openings OPBMr, OPBMg, OPBMb of the light blocking layer 220 can be arranged in eight directions.

Here, the calculation is based on 180 degrees rather than 360 degrees because the two angles with a difference of 180 degrees are in substantially the same direction.

An embodiment of FIG. 32, element (B) with an angle interval of 11.25 degrees has twice as many angles as the embodiment of FIG. 32, element (A), and the major axis of the second opening OPBMr, OPBMg, OPBMb of the light blocking layer 220 is arranged in a total of 16 directions.

In the two embodiments arranged as shown in FIG. 32, the major axis arrangement angle of the second openings OPBMr, OPBMg, OPBMb of the light blocking layer 220 is greater than 4, so the diffraction patterns are mixed without a specific direction and the user experiences diffraction, and display quality can be increased because the directionality or color separation of the pattern cannot be easily recognized.

In FIG. 32, the major axes of the plurality of second openings OPBMr, OPBMg, OPBMb of the color filter are arranged at equal intervals, but depending on the embodiment, they may be arranged at irregular intervals at an angle of 45 degrees or less.

In the above, as shown in FIG. 29, examination was done of an embodiment in which the opening OP of the pixel defining layer 380 has a circular shape, the second opening OPBM of the light blocking layer 220 has an oval shape, and the circle and the oval are in contact with each other in a plan view.

However, either the opening OP of the pixel defining layer 380 or the second opening OPBM of the light blocking layer 220 may be relatively large, and this embodiment will be described with reference to FIG. 33 to FIG. 39.

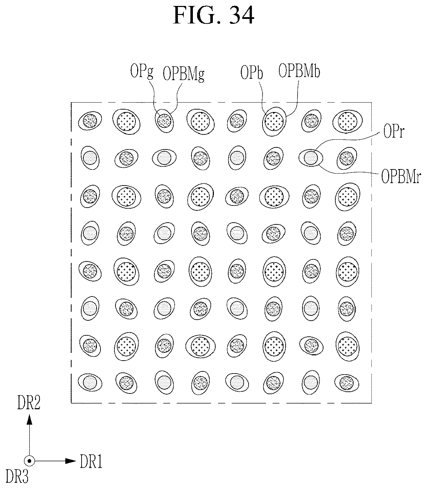

First, through FIG. 33 and FIG. 34, the opening OP of the pixel defining layer 380 is located within the second opening OPBM of the light blocking layer 220, so that the opening OP of the pixel defining layer 380 blocks light, an embodiment that is not obscured by the light blocking layer 220 will be examined.

FIG. 33 and FIG. 34 are plan views of a portion of a display panel according to an embodiment.

First, in FIG. 33, the second opening OPBM of the light blocking layer 220 may be formed at various intervals (gap1, gap2, gap3) depending on how large the opening OP of the pixel defining layer 380 is formed.

FIG. 33, shows a plan view in which the second opening OPBM of the light blocking layer 220 is large, so that the circular opening OP of the pixel defining layer 380 is located within the second opening OPBM of the light blocking layer 220.

Therefore, in the embodiment of FIG. 33, the radius value (Rop) of the circular shape of the opening OP of the pixel defining layer 380 is the minor axis length of the elliptical shape of the second opening OPBM of the light blocking layer 220. It is smaller than the half value (Ropbm1) and smaller than the half value (Ropbm2) of the major axis length of the oval shape.

The half value (Ropbm2) of the major axis length of the elliptical shape may be larger than the radius value (Rop) of the circular shape of the opening OP of the pixel defining layer 380 by more than 0 µm and less than or equal to 20 µm.

For example, in FIG. 33, element (A), the minimum horizontal gap of gap1 in the plan view between the second opening OPBM of the light blocking layer 220 and the opening OP of the pixel defining layer 380 is relatively small compared to gap2 and gap3, but in FIG. 33, element (B) it has a relatively large minimum horizontal gap of gap2, and FIG. 33, element (C) shows the largest minimum horizontal gap of gap3.

In FIG. 33, element (A) to FIG. 33, element (C), the elliptical eccentricity of the second opening OPBM of the light blocking layer 220 may also be different from each other.

Here, the eccentricity of the oval shape may range from 0.2 to 0.85.

In the embodiment of FIG. 33, due to errors during actual processing, a portion of one side of the opening OP of the pixel defining layer 380 does not overlap the second opening OPBM of the light blocking layer 220 and the light blocking layer 220.

Additionally, the opening OP of the pixel defining layer 380 is located within the second opening OPBM of the light blocking layer 220, but may be located closer to one boundary or may be in planar contact with one boundary.

FIG. 34 shows an embodiment in which the elliptical major axes of the second openings OPBMr, OPBMg, OPBMb of the light blocking layer 220 are arranged at various angles. Additionally, the second openings OPBMr, OPBMg, OPBMb of the light blocking layer 220 in FIG. 34 have different eccentricities for each color.

Depending on the embodiment, the two openings corresponding to the same color among the second openings OPBMr, OPBMg, OPBMb of the light blocking layer 220 may have different eccentricities, and depending on the embodiment, all of the light blocking layers 220 may have different eccentricities, and the second openings OPBMr, OPBMg, OPBMb may have the same eccentricity.

Additionally, the major axes of the elliptical second openings OPBMr, OPBMg, OPBMb of the light blocking layer 220 may be arranged at four or more angles or may be arranged at intervals of 45 degrees or less.

The embodiment of FIG. 33 may also be arranged with 8 major axis directions at angular intervals of 22.5 degrees, as shown in FIG. 32, element (A), or may be arranged with 16 major axis directions at angular intervals of 11.25 degrees, as shown in FIG. 32, element (B).

In FIG. 34, the major axis directions of the plurality of second openings OPBMr, OPBMg, OPBMb of the color filter are arranged at equal intervals, but in FIG. 33, depending on the embodiment, they may be arranged at irregular intervals at an angle of 45 degrees or less.

In the above, an embodiment in which the opening OP of the pixel defining layer 380 is located within the second opening OPBM of the light blocking layer 220 has been examined.

In the following, examination will be done of the structure in which the second opening OPBM of the light blocking layer 220, which is relatively small, covers part of the circular opening OP of the pixel defining layer 380 on the flat light blocking layer 220, through FIG. 35 to FIG. 39.

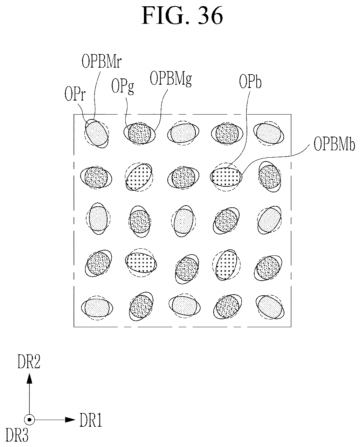

First, the relationship between the second opening OPBM of the light blocking layer 220 and the opening OP of the pixel defining layer 380 will be examined through FIG. 35 and FIG. 36.

FIG. 35 and FIG. 36 are plan views of a portion of a display panel according to an embodiment.

In FIG. 35, only the opening OP of one pixel defining layer 380 and the second opening OPBM of the light blocking layer 220 corresponding thereto are shown.

The second opening OPBM of the light blocking layer 220 overlaps a portion of the opening OP of the pixel defining layer 380, and the remaining portion of the opening OP of the pixel defining layer 380 overlaps the light blocking layer 220.

As a result, the light emitting layer located within the opening OP of the pixel defining layer 380 may be partially obscured by the light blocking layer 220.

In FIG. 35, part of the opening OP of the pixel defining layer 380 is shown with a dotted line to indirectly show that the corresponding part is located below and covered by the light blocking layer 220.

In the embodiment of FIG. 35, due to errors during actual processing, the portion of the opening OP of the pixel defining layer 380 that is obscured by the light blocking layer 220 might not be constant on both sides and the area on one side may be larger.

Additionally, one side of the opening OP of the pixel defining layer 380 may be located within or in contact with the second opening OPBM of the light blocking layer 220, and only the other side may be covered by the light blocking layer 220.

As shown in FIG. 35, if a portion of the opening OP of the pixel defining layer 380 is covered by the light blocking layer 220, the light emitted from the light emitting layer within the opening OP might not be provided to the front, which may be inefficient in terms of light.

However, the size of the opening OP of the pixel defining layer 380 is related to the lifespan of the light emitting layer located therein, so the size of the opening OP might not be reduced to maintain the lifespan above a certain level.

The opening OP of the pixel defining layer 380 and the second opening OPBM of the light blocking layer 220 having the same structure as shown in FIG. 35 may be arranged as shown in FIG. 36.

Referring to FIG. 36, the elliptical major axes of the second openings OPBMr, OPBMg, OPBMb of the light blocking layer 220 are arranged at various angles.

Here, the openings OPr, OPg, OPb of the pixel defining layer 380 each have a circular shape, and a part of the openings OPr, OPg, OPb overlaps with the second opening OPBMr, OPBMg, OPBMb of the light blocking layer 220 and is not covered by the light blocking layer 220, but the remaining part is covered by the light blocking layer 220 because it does not overlap the second opening OPBMr, OPBMg, OPBMb of the light blocking layer 220.

Additionally, the second openings OPBMr, OPBMg, OPBMb of the light blocking layer 220 in FIG. 36 have different eccentricities for each color.

Depending on the embodiment, the two openings corresponding to the same color among the second openings OPBMr, OPBMg, OPBMb of the light blocking layer 220 may have different eccentricities. However, in some embodiments, all second openings OPBMr, OPBMg, OPBMb of the light blocking layer may have the same eccentricity.

Here, the eccentricity of the oval shape may range from 0.2 to 0.85.

Additionally, the major axes of the elliptical second openings OPBMr, OPBMg, OPBMb of the light blocking layer 220 may be arranged at four or more angles or may be arranged at intervals of 45 degrees or less.

The embodiment of FIG. 35 may also be arranged with 8 major axis directions at angular intervals of 22.5 degrees, as shown in FIG. 32, element (A), or may be arranged with 16 major axis directions at angular intervals of 11.25 degrees, as shown in FIG. 32, element (B).

In FIG. 36, the major axis directions of the plurality of second openings OPBMr, OPBMg, OPBMb of the color filter are arranged at equal intervals, but in the embodiment of FIG. 33, they may be arranged at irregular intervals at an angle of 45 degrees or less depending on the embodiment.

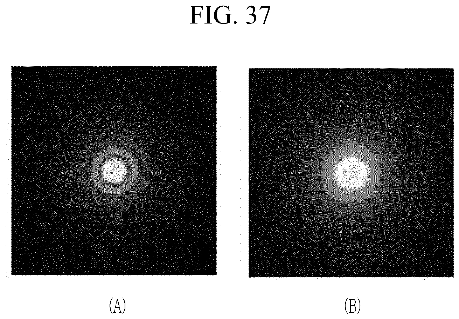

As described above, the diffraction characteristics of external light reflected in the embodiment in which some of the openings OPr, OPg, OPb of the pixel defining layer 380 are covered by the light blocking layer 220 are examined in FIG. 37.

FIG. 37 is a photograph of the reflection characteristics of the comparative example and the example of FIG. 36.

FIG. 37, element (A) is a diffraction pattern of a comparative example, and as shown in FIG. 10 described above, both the openings OPr, OPg, OPb of the pixel defining layer 380 and the second openings OPBMr, OPBMg, OPBMb of the light blocking layer 220 are circular in a diffraction pattern.

FIG. 37, element (B) shows the diffraction pattern and color dispersion of reflected light for the embodiment of FIG. 36.

Comparing FIG. 37, element (B) and FIG. 37, element (A), it can be seen that the diffraction pattern in FIG. 37, element (B) is relatively unclear and the shape of the ring is not clearly visible.

In FIG. 35 and FIG. 36, some of the openings OPr, OPg, OPb of the pixel defining layer 380 are covered by the light blocking layer 220, but as shown in FIG. 29, the openings OPr, OPg, OPb are in contact with the second openings OPBMr, OPBMg, OPBMb of the light blocking layer 220, or the pixel defining layer 380 is within the second openings OPBMr, OPBMg, OPBMb of the light blocking layer 220 as shown in FIG. 33, and it can be seen that there is no significant difference in the diffraction pattern from the example in which all the openings OPr, OPg, OPb are located.

For example, even in the embodiment of FIG. 36, the gap between the two openings is not constant, so the resulting diffraction patterns may be different, and as each diffraction pattern is mixed, the overall diffraction pattern is formed blurry.

In addition, since the elliptical second openings OPBMr, OPBMg, OPBMb of the light blocking layer 220 are arranged at various angles, the directions of the diffraction patterns are varied and are mixed with each other, forming a blur, and a scattering effect occurs.

As a result, it is difficult for users to recognize (e.g., see) the diffraction pattern, and the extent to which display quality deteriorates is reduced.

In the above, the openings OPr, OPg, OPb of the pixel defining layer 380 and the second openings OPBMr, OPBMg, OPBMb of the light blocking layer 220 are in contact with each other in a plan view or the second openings of the light blocking layer 220 in a plan view are in contact with each other, and embodiments were described separately based on whether all or part of the openings OPr, OPg, OPb of the pixel defining layer 380 are located within the openings OPBMr, OPBMg, OPBMb.

Each of these embodiments can reduce the reflection diffraction of external light by varying the arrangement of the major axis direction of the second openings OPBMr, OPBMg, OPBMb of the light blocking layer 220 or by variously modifying the eccentricity of the ellipse.

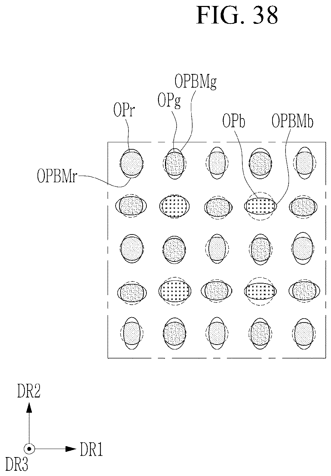

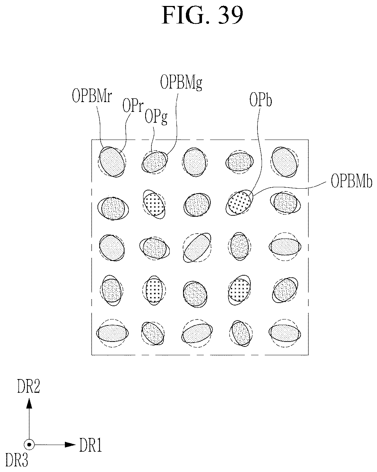

Hereinafter, through FIG. 38 and FIG. 39, an embodiment in which the eccentricity of the ellipse is varied or the arrangement of the major axis is varied is discussed.

FIG. 38 and FIG. 39 are plan views of a portion of a display panel according to an embodiment.

FIG. 38 shows an embodiment in which the second opening OPBM of the light blocking layer 220 is formed at various eccentricities, and FIG. 39 shows an embodiment in which the second opening OPBM of the light blocking layer 220 has various angles and is formed at various eccentricities.

Depending on the embodiment, the second opening OPBM of the light blocking layer 220 is formed with the same eccentricity, but may be formed at various angles.

Looking at the embodiment of FIG. 38, it is as follows.

In FIG. 38, the second openings OPBMr, OPBMg, OPBMb of the light blocking layer 220 have an elliptical shape with two or more different eccentricities.

Depending on the embodiment, each opening of the same color may have an oval shape with different eccentricities.

Here, the eccentricity of the oval shape may range from 0.2 to 0.85.

In FIG. 38, the major axis direction of the ellipse has only two directions of the first direction DR1 and the second direction DR2.

Depending on the embodiment, it may have four or fewer directions.

Through FIG. 38, the planar structure of the second openings OPBMr, OPBMg, OPBMb of the light blocking layer 220 will be examined in detail.

In FIG. 38, the openings OPr, OPg, OPb of the pixel defining layer 380 have a circular shape, and the second openings OPBMr, OPBMg, OPBMb of the light blocking layer 220 have an oval planar shape.

Some of the openings OPr, OPg, OPb of the pixel defining layer 380 do not overlap in plan with the second openings OPBMr, OPBMg, OPBMb of the corresponding light blocking layer 220, and thus are blocked by the light blocking layer 220.

The second openings OPBMr, OPBMg, OPBMb of the light blocking layer 220 are elliptical and have their major axes arranged in only two directions of the first direction DR1 and the second direction DR2.

The red second opening OPBMr, the green second opening OPBMg, and the blue second opening OPBMb of the color filter may each be formed as an ellipse with at least two different eccentricities.

In addition, in the embodiment of FIG. 38, the second openings OPBMr, OPBMg, OPBMb of the light blocking layer 220 of the same color may have at least two different eccentricities and have different oval planar shapes.

In the case of the embodiment of FIG. 38 where the openings are of the same color but have different elliptical shapes with different eccentricities, the elliptical shapes with different eccentricities may be arranged in various positions at various ratios.

Depending on the embodiment, the same number of oval shapes with different eccentricities may be included in the display area, and depending on the embodiment, they may be included in different numbers.

Referring to FIG. 38, the angle formed by each major axis of the plurality of second openings OPBMr, OPBMg, OPBMb of the color filter is 0 degrees with respect to the first direction DR1 or the second direction DR2.

In an embodiment in which the eccentricity of the ellipse is formed in various ways, the number of angles formed by the major axis of the ellipse may be four or less.

For example, in the embodiment of FIG. 38, various elliptical shapes with different eccentricities are formed to reduce color separation of external light or to generate a constant diffraction pattern or color separation regardless of angle.

Therefore, the embodiment of FIG. 38 can enable constant color separation and/or constant diffraction even without varying the direction of the major axis of the ellipse.

The embodiment of FIG. 39 will be examined.

In FIG. 39, the second openings OPBMr, OPBMg, OPBMb of the light blocking layer 220 have oval shapes with different eccentricities even for the same color. Additionally, the angles formed by the major axes of the second openings OPBMr, OPBMg, OPBMb of the light blocking layer 220 can be more than four different angles or spaced at intervals of 45 degrees or less.

Here, the eccentricity of the oval shape may range from 0.2 to 0.85.

In the embodiment of FIG. 39, the eccentricity of the ellipse is varied and the major axis direction of the ellipse is also arranged in various ways.

Therefore, the plurality of openings OPr, OPg, OPb of the pixel defining layer 380 or the plurality of second openings OPBMr, OPBMg, OPBMb of the color filter are four or more or are spaced at an angle of 45 degrees or less. The eccentricity of the ellipse is additionally varied so that color separation of external light occurs less or a constant, unclear diffraction pattern occurs regardless of the angle.

Depending on the embodiment, the major axis direction of the plurality of second openings OPBMr, OPBMg, OPBMb of the color filter may be formed at equal or irregular intervals.

Although FIG. 38 and 39 show modified embodiments based on the embodiment of FIG. 35, the embodiment of FIG. 29 or FIG. 33 can be similarly modified.

A rough comparison of the above embodiments of FIG. 38 and FIG. 39, including additional embodiments in which only the major axis direction of the ellipse is formed in various ways while keeping the eccentricity constant, may be as shown in Table 2 below.

**[Table 2]**

| item | One embodiment | FIG. 38 embodiment | FIG. 39 embodiment |
|---|---|---|---|
| pixel define layer opening | circular shape | circular shape | circular shape |
| eccentricity of the second opening ellipse of the color filter | red, green, blue same eccentricity | eccentricity 2 or more different eccentricity by color opening of the same color has a different eccentricity (a circle with an eccentricity of 0 is also possible) | eccentricity 2 or more different eccentricity by color opening of the same color has a different eccentricity (a circle with an eccentricity of 0 is also possible) |
| light blocking layer second opening area (aperture ratio) | same | area varies depending on eccentricity | area varies depending on eccentricity |
| arrange ratio | equalization arrange | total number of ellipses with different eccentricities is the same or different | total number of ellipses with different eccentricities is the same or different |
| light blocking layer second opening ellipse major axis angle | 4 or more angles | 45 degrees, 2 total (4 or fewer angles are also possible) | can be positioned at 4 or more angles |

In the embodiments of FIG. 29, FIG. 33, and FIG. 35, the second opening OPBM of one light blocking layer 220 has one eccentricity.

However, depending on the embodiment, as shown in FIG. 17, the second opening OPBM of one light blocking layer 220 may be formed by merging at least two elliptical shapes with different eccentricities.

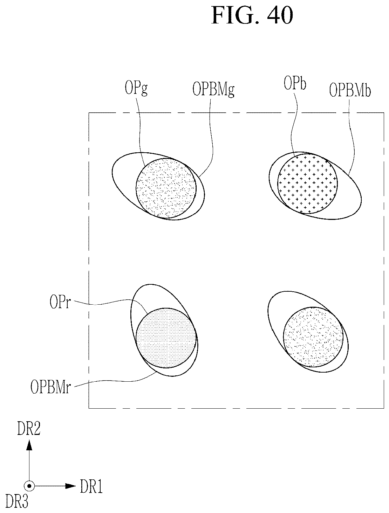

Hereinafter, with reference to FIG. 40, the opening OP of the pixel defining layer 380 has a circular shape, and the second opening OPBM of the light blocking layer 220 is formed by merging at least two elliptical shapes with different eccentricities, and an example of one of the embodiments having an oval shape formed will be examined.

FIG. 40 is a diagram showing a structure combining ellipses with different eccentricities.

In FIG. 40, an example is shown where the second opening OPBMr, OPBMg, OPBMb of the light blocking layer 220 and the opening OPr, OPg, OPb of the pixel defining layer 380 are arranged in various major axis directions using the merged ellipse shape in the same manner as in FIG. 17, element (C).

In the embodiment of FIG. 40, the second openings OPBMr, OPBMg, OPBMb of the light blocking layer 220 and the openings OPr, OPg, OPb of the pixel defining layer 380 may contact each other as shown in FIG. 29.

However, depending on the embodiment, as shown in FIG. 33, the second openings OPBMr, OPBMg, OPBMb of the light blocking layer 220 may be formed larger than the openings OPr, OPg, OPb of the pixel defining layer 380, and as shown in FIG. 35, the second openings OPBMr, OPBMg, OPBMb of the light blocking layer 220 may have a structure that covers a portion of the openings OPr, OPg, OPb of the pixel defining layer 380.

In FIG. 40, only one unit pixel is shown, and one unit pixel includes one red opening OPr, OPBMr, one blue opening OPb, OPBMb, and two green openings OPg, OPBMg, showing a unit pixel where the green, red and blue openings are divided.

In the embodiment of FIG. 40, the openings OPr, OPg, OPb of the pixel defining layer 380 have a circular shape, and the second openings OPBMr, OPBMg, OPBMb of the light blocking layer 220 have a merged oval shape, and the direction of each major axis may also be different.

As shown in FIG. 40, the embodiment using an ellipse that is a combination of two ellipses with different eccentricities also uses the openings OPr, OPg, OPb of the pixel defining layer 380 and the second openings OPBMr, OPBMg, OPBMb of the light blocking layer 220 may have four or more angles, and the angles formed by the major axes may be arranged at intervals of 45 degrees or less.

Additionally, the eccentricities of the two ellipses used for merging may vary, so the size of the merged ellipses may also vary.

Additionally, depending on the embodiment, two ovals with different eccentricities for each color can be combined, and even if they are the same color, two ovals with different eccentricities can be combined to form various ovals.

On the other hand, the openings OPr, OPg, OPb of the pixel defining layer 380 and the corresponding second openings OPBMr, OPBMg, OPBMb of the light blocking layer 220 can have a constant distance in a plan view or a horizontal distance of more than 0 µm and less than or equal to 20 µm.

Below is an examination of the reflected light diffraction characteristics of an embodiment using an ellipse shape formed by combining two ellipses of different eccentricities.

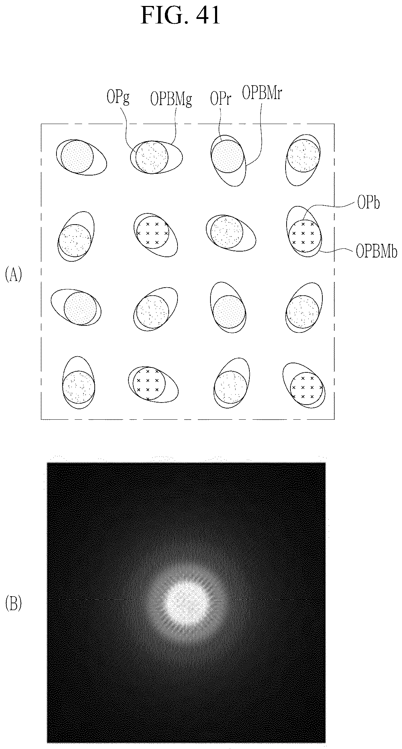

FIG. 41 is a diagram showing a merged elliptical structure and its reflection characteristics according to an embodiment.

FIG. 41, element (A) shows an embodiment in which the openings of each color have the same merged oval shape, but the major axis direction has four or more angles.

In FIG. 41, element (B), the diffraction characteristics of the reflected light in FIG. 41, element (A) are shown.

Compared to the comparative example of FIG. 37, element (A), it can be seen that the diffraction characteristic of FIG. 41, element (B) has a blurred reflection diffraction pattern, the ring shape is less clear, and the separated colors are difficult for the user to see.

As a result, the example shown in FIG. 41, element (A) can also have increased display quality compared to the comparative example.

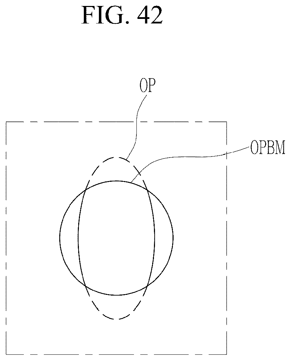

Depending on the embodiment, the second openings OPBMr, OPBMg, OPBMb of the light blocking layer 220 have a circular shape, and the openings OPr, OPg, OPb of the pixel defining layer 380 have an oval shape or an approximately oval shape, which will be briefly examined through FIG. 42.

FIG. 42 is a plan view of a portion of a display panel according to an embodiment.

In FIG. 42, only the opening OP of one pixel defining layer 380 and the second opening OPBM of the light blocking layer 220 corresponding thereto are shown.

The second opening OPBM of the light blocking layer 220 has a circular shape, and the opening OP of the pixel defining layer 380 has an oval shape.

Additionally, the second opening OPBM of the light blocking layer 220 overlaps a portion of the opening OP of the pixel defining layer 380, and the remaining portion is covered by the light blocking layer 220.

As a result, the light emitting layer located within the opening OP of the pixel defining layer 380 may be partially obscured by the light blocking layer 220.

In FIG. 42, part of the opening OP of the pixel defining layer 380 is shown with a dotted line to indirectly show that the corresponding part is located below and is covered by the light blocking layer 220.

In the embodiment of FIG. 42, due to errors during actual processing, the portion of the opening OP of the pixel defining layer 380 that is obscured by the light blocking layer 220 might not be constant on both the top and bottom, and the area on one side may be larger.

Additionally, one side of the opening OP of the pixel defining layer 380 may be located within or in contact with the second opening OPBM of the light blocking layer 220, and only the other side may be covered by the light blocking layer 220.

As shown in FIG. 42, if a portion of the opening OP of the pixel defining layer 380 is covered by the light blocking layer 220, the light emitted from the light emitting layer within the opening OP might not be provided to the front, thereby reducing light efficiency.

However, the size of the opening OP of the pixel defining layer 380 is related to the lifespan of the light emitting layer located therein, so the size of the opening OP might not be reduced to maintain the lifespan above a certain level.

According to the embodiment, the major axis direction of the opening OP of the pixel defining layer 380 can be variously arranged, and the angle formed by the major axis can have four or more angles. Also, the angle formed by the major axis can be arranged at intervals of 45 degrees or less.

Depending on the embodiment, ovals with different eccentricities may have a merged shape.

The eccentricities of the two ellipses used for merging may vary, and the size of the merged ellipses may also vary.

Additionally, depending on the embodiment, two ovals with different eccentricities for each color can be combined, and even if they are the same color, two ovals with different eccentricities can be combined to form various ovals.

The opening OP of the pixel defining layer 380 and the corresponding second opening OPBM of the light blocking layer 220 may have a horizontal gap of 0 µm or more and 20 µm or less.

Some variations of Table 2 may also be applied to the embodiment of FIG. 42.

The embodiment of FIG. 42 is similar to the embodiment of FIG. 35 described above, and the diffraction patterns generated may be different because the distance between the two openings is not constant, and as each diffraction pattern is mixed, the overall diffraction pattern is formed blurry.

As a result, it is difficult for users to recognize (e.g., see) the diffraction pattern, and the extent to which display quality deteriorates is reduced.

Depending on the embodiment, the second opening OPBM of the light blocking layer 220 has a circular shape, and the opening OP of the pixel defining layer 380 has an elliptical shape, and the two openings are in contact with each other, or a variation in which the opening is located within another opening is also possible.

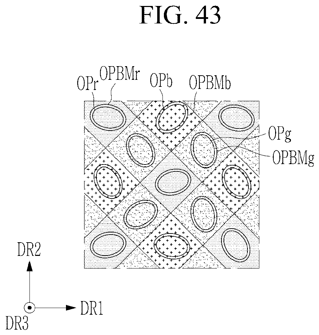

Hereinafter, the planar structure of the color filters 230R, 230G, 230B according to an embodiment will be examined in detail through FIG. 43.

FIG. 43 is a plan view including a color filter of a display area according to an embodiment.

FIG. 43 is a diagram illustrating more clearly the planar structure of the color filters 230R, 230G, 230B in the embodiment of FIG. 26, element (C).

Referring to FIG. 6, which is a cross-sectional view, adjacent color filters 230R, 230G, 230B have a structure in which they overlap each other on the light blocking layer 220.

The planar structure of this overlapping area may vary, and one of the planar structures in the embodiment may have a diamond shape, as shown in FIG. 43.

For example, each of the color filters 230R, 230G, 230B covers the opening OP of the corresponding pixel defining layer 380 and the second opening OPBM of the light blocking layer 220, and has a diamond shape.

Referring to FIG. 43, the color filters 230R, 230G, 230B are each shown with different hatching, and the boundary between adjacent color filters 230R, 230G, 230B is shown as a single line.

However, some areas of the actually adjacent color filters 230R, 230G, 230B may overlap each other as shown in FIG. 6, and the overlapping portion is located at the boundary line of the color filters 230R, 230G, 230B in FIG. 43.

Depending on the embodiment, a light blocking area of the color filter may be formed in which at least two color filters 230R, 230G, 230B overlap, instead of the light blocking layer 220.

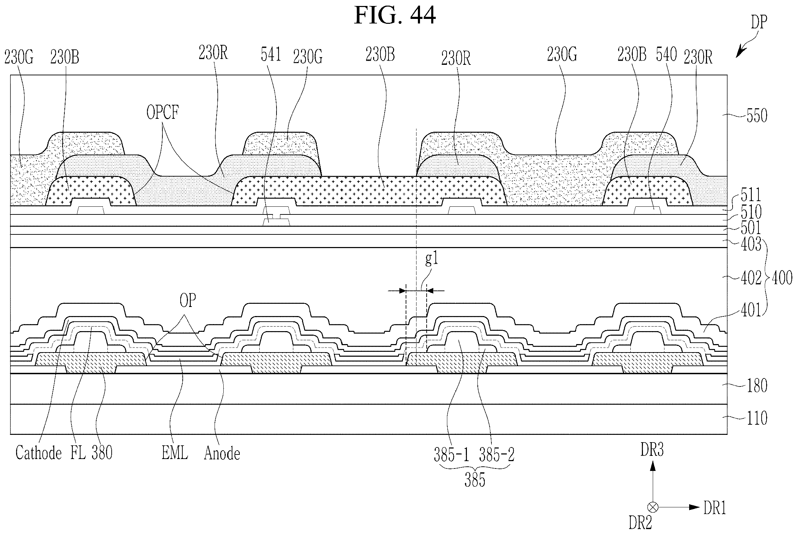

Hereinafter, through FIG. 44 to FIG. 48, an embodiment that does not include a light blocking layer and includes a light blocking area of a color filter in which at least two color filters 230R, 230G, 230B are overlapped will be described.

First, the modified structure of FIG. 6 through FIG. 44 and FIG. 45 will be examined.

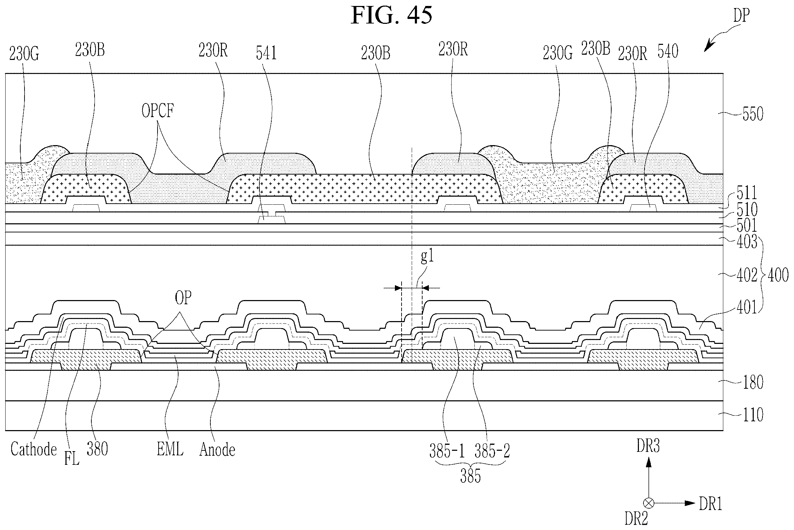

FIG. 44 and FIG. 45 are schematic cross-sectional views of a display panel according to an embodiment.

Hereinafter, the structure of the light emitting display panel DP according to an embodiment will first be looked at with reference to FIG. 44, and to the extent that an element is not described in detail with respect to this figure, it may be understood that the element is at least similar to a corresponding element that has been described elsewhere within the present disclosure.

The light emitting display panel DP according to the embodiment of FIG. 44 can display an image by forming light emitting diodes on a substrate 110, and can detect a touch by including a plurality of sensing electrodes 540 and 541. The light emitted from the light emitting diode, including the color filters 230R, 230G, 230B, also has the color characteristics of the color filters 230R, 230G, 230B.

A black light blocking layer that blocks visible light might not be formed, and instead of a light blocking layer, at least two color filters may be overlapped to block visible light.

An area that blocks visible light by overlapping at least two color filters is called a light blocking area. In the embodiment of FIG. 44, the blue color filter 230B, the red color filter 230R, and the green color filter 230G are sequentially used.

The order in which color filters are stacked may vary depending on the embodiment.

In addition, a polarizer is not disposed on the front surface of the light emitting display panel DP according to the embodiment of FIG. 44, and instead, the pixel defining layer 380 is formed of a black organic material, and at least the upper part of the pixel defining layer 380 is formed, two or more color filters overlap to form a light blocking area, so that even if external light enters the interior, it is reflected from an anode, etc. and is not transmitted to the user.

For example, color filters 230R, 230G, 230B are located on the third sensing insulating layer 511.

The color filters 230R, 230G, 230B are a red color filter 230R that transmits red light, a green color filter 230G that transmits green light, and a blue color filter 230B that transmits blue light.

Each of the color filters 230R, 230G, 230B may overlap the anode of the light emitting diode in a plan view.

Since the light emitted from the emitting layer EML may change to a corresponding color as it passes through a color filter, all light emitted from the emitting layer EML may have the same color.

However, the light emitting layer EML may emit light of different colors, and the displayed color can be strengthened by passing through a color filter of the same color.

Depending on the embodiment, the color filters 230R, 230G, 230B may be replaced with a color conversion layer or may further include a color conversion layer.

The color conversion layer may include quantum dots.

In the embodiment of FIG. 44, a black light blocking layer that blocks visible light is not formed, and a light blocking area formed by overlapping at least two color filters is formed instead of the light blocking layer.

In the embodiment of FIG. 44, the light blocking area includes a blue color filter 230B, a red color filter 230R, and a green color filter 230G sequentially stacked.

The order in which color filters are stacked may vary depending on the embodiment.

The light blocking area where two or more color filters overlap may overlap the sensing electrodes 540 and 541 in a plan view, and may be positioned not to overlap the anode in a plan view.

This is to ensure that the anode and the light emitting layer EML capable of displaying an image are not obscured by the light blocking area and the sensing electrodes 540 and 541.

Referring to FIG. 44, the light blocking area of the color filter where three color filters overlap is located only in the area that overlaps the pixel defining layer 380 in a plan view, and one side of the light blocking area of the color filter is placed inward from the corresponding side of the pixel defining layer 380.

Only one color filter can be located in an area excluding the light blocking area, and light of that color filter is transmitted to form a light transmitting area of the color filter.

Hereinafter, the light transmitting area of the color filter where only one color filter is located is also referred to as the second opening OPCF of the light blocking area because light is transmitted therethrough.

The second opening OPCF of the light blocking area is an opening located in a light blocking area where two or more color filters overlap and may correspond to an area where only one color filter is located.

The second opening OPCF of the light blocking area of the color filter may correspond to the second opening OPBM of the light blocking layer 220 described above.

The area of the second opening OPCF in the light blocking area is formed larger than the opening OP of the pixel defining layer 380, and the opening OP of the pixel defining layer 380 in a plan view can be located within the second opening OPCF of the light blocking area.

In addition, one side of the spacer 385 is positioned inward at a certain distance (g1) from one side of the pixel defining layer 380, and the spacer 385 is also positioned inward to one side of the light blocking area 380, and the spacer 385 is also positioned inward on one side of the light blocking area.

As a result, when viewed from the front of the display panel DP, the spacer 385 may be obscured by the light blocking area and might not be visible.

When external light is incident, it may pass through the second opening OPCF of the light blocking area of the color filter and then be reflected on the sidewall of the opening OP of the pixel defining layer 380.

The sidewall of the opening OP of the pixel defining layer 380 is curved and color separation occurs depending on the position of reflection, so that the reflected light can appear in various colors, like a rainbow.

Since this color-separated reflected light can easily be seen by the user and deteriorate the display quality, in embodiments such as those shown in FIG. 7, the second opening OPBM of the light blocking layer 220 is changed to the second opening of the light blocking area of the color filter, and it can be applied instead of the second opening OPCF of the color filter's shaded area, which aids the display quality.

For example, at least one of the second opening OPCF of the light blocking area of the color filter and the opening OP of the pixel defining layer 380 have an ellipse shape, and the direction of the ellipse or the eccentricity of the ellipse is varied to reduce color separation or to allow white reflected light to be seen.

Depending on the embodiment, it may be formed to have a shape similar to an oval or approximately an oval, and its direction or eccentricity may be changed in various ways.

In addition, various modifications to the previously described second opening OPBM of the light blocking layer 220 and the corresponding opening OP of the pixel defining layer 380 may form the second opening OPCF of the light blocking area of the color filter and the opening OP of the pixel defining layer 380.

A planarization layer 550 covering the color filters 230R, 230G, 230B is positioned on the color filters 230R, 230G, 230B.

The planarization layer 550 is used to planarize the upper surface of the light emitting display panel and may be a transparent organic insulating film containing polyimide, polyamide, acrylic resin, benzocyclobutene, and/or phenol resin.

Depending on the embodiment, a low refractive layer and an additional planarization layer may be further positioned on the planarization layer 550 to increase front visibility and light output efficiency of the display panel.

Light can be refracted and emitted toward the front by the low refractive layer and the additional flattening layer with high refractive characteristics.

In this case, depending on the embodiment, the planarization layer 550 may be omitted and a low refractive layer and an additional planarization layer may be located directly on the color filter.

In this embodiment, a polarizer is not included on top of the planarization layer 550.

The polarizer can prevent display quality from deteriorating when external light is incident and reflected by the anode or the sidewall of the opening OP of the pixel defining layer 380, which is visible to the user.

However, the polarizer has the disadvantage of consuming more power to display a certain luminance by not only reducing the reflection of external light but also reducing the light emitted from the light emitting layer EML.

To reduce power consumption, the light emitting display device of this embodiment might not include a polarizer.

Additionally, in this embodiment, the side of the anode is covered by the pixel defining layer 380 to reduce the degree of reflection from the anode, and a light blocking area where two or more color filters are overlapped is also formed to prevent light from entering. It also includes a structure to reduce the degree of display quality and prevent deterioration of display quality due to reflection.

Therefore, there is no need to separately form the polarizer on the front of the light emitting display panel DP.

In the embodiment of FIG. 44, the light blocking area where two or more color filters are overlapped is focused on an embodiment in which three color filters are overlapped.

However, depending on the embodiment, two color filters may be overlapped to form a light blocking area of the color filter, which is shown in FIG. 45.

FIG. 45 is a drawing corresponding to FIG. 6 and FIG. 44, only the color filters 230R, 230G, 230B are different from FIG. 44, so the lower structure of the third sensing insulating layer 511 is the same as that of FIG. 44.

Hereinafter, the upper structure of the third sensing insulating layer 511 will mainly be described, which is different from that of FIG. 44.

Referring to FIG. 45, a light blocking layer that blocks visible light is not formed, and a blue color filter 230B and a red color filter 230R are sequentially overlapped to block visible light.

The order in which color filters are stacked may vary depending on the embodiment.

For example, the light blocking area where two color filters overlap has a blue color filter 230B and a red color filter 230R, and a green color filter 230G is overlapped in some areas of the light blocking area of the color filter.

However, the green color filter 230G is an embodiment in which the light blocking area of the color filter is not formed entirely, and the light blocking area of the color filter is formed using only two color filters, unlike the embodiment of FIG. 44.

The light blocking area where two color filters overlap is located only in the area that overlaps the pixel defining layer 380 in a plan view, and one side of the light blocking area of the color filter is positioned inward from the corresponding side of the pixel defining layer 380.

In the area excluding the light blocking area of the color filter, only one color filter can be located, and the light of the color of the color filter is transmitted to form the second opening OPCF of the light transmitting area or the light blocking area of the color filter.

The area of the second opening OPCF is formed larger than the opening OP of the pixel defining layer 380, and the opening OP of the pixel defining layer 380 may be located within the second opening OPCF in the light blocking area of the color filter.

In addition to the pixel defining layer 380, the light blocking area of the color filter overlaps the spacer 385 and the plurality of sensing electrodes 540 and 541 in a plan view.

For example, the light blocking area of the color filter is disposed inward at a certain distance (g1) from the corresponding side of the pixel defining layer 380 of the spacer 385, and the spacer 385 blocks the light of the color filter, it is disposed inward to one side of the area.

Additionally, the plurality of sensing electrodes 540 and 541 are covered in a plan view with the light blocking area of the color filter.

As a result, when viewed from the front of the display panel DP, the spacer 385 and the plurality of sensing electrodes 540 and 541 might not be visible because they are obscured by the light blocking area of the color filter.

Depending on the embodiment, the color filters 230R, 230G, 230B may be replaced with a color conversion layer or may further include a color conversion layer.

The color conversion layer may include quantum dots.

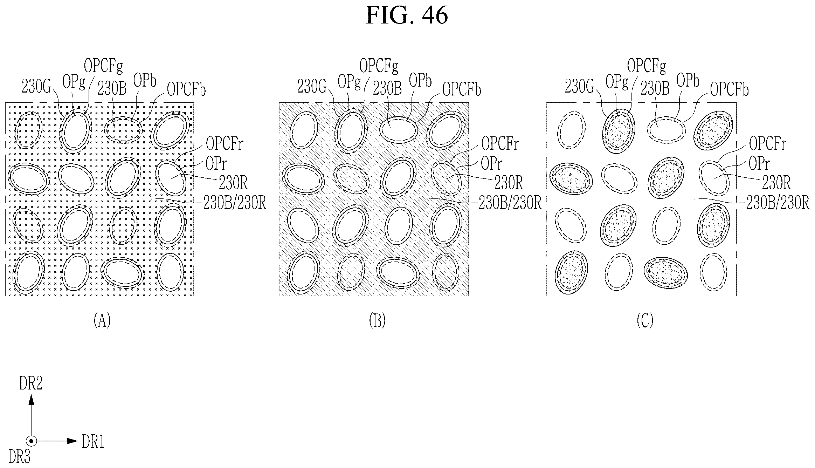

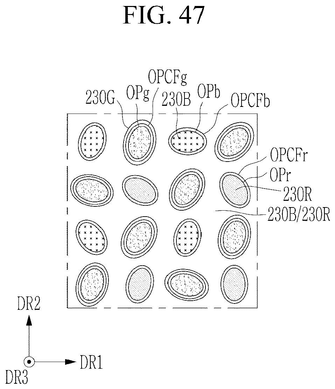

An embodiment having a cross-sectional structure as shown in FIG. 45 may have a planar structure as shown in FIG. 46 and FIG. 47.

First, the planar structure of each color filter 230R, 230G, 230B will be examined through FIG. 46.

FIG. 46 is a plan view showing color filters of a display area according to an embodiment.

FIG. 46, element (A) shows the layer where the blue color filter 230B is formed, and a hatch is drawn at the portion where the blue color filter 230B is located.

The remaining layers in FIG. 47 are shown with dotted lines.

Based on FIG. 46, element (A), the blue color filter 230B is located in the light blocking area and the blue-light transmission area through which blue light is transmitted, and is not formed in the red- and green-light transmission areas.

Additionally, FIG. 46, element (B) shows the layer where the red color filter 230R is formed, and a hatch is drawn at the portion where the red color filter 230R is located.

The remaining layers in FIG. 47 are shown with dotted lines.

Based on FIG. 46, element (B), the red color filter 230R is located in the light blocking area and the red-light transmission area through which red light is transmitted, and is not formed in the blue- and green-light transmission areas.

FIG. 46, element (C) shows the layer where the green color filter 230G is formed, and a hatch is drawn at the portion where the green color filter 230G is located.

The remaining layers in FIG. 47 are shown with dotted lines.

Based on FIG. 46, element (C), the green color filter 230G has an island-like structure and is located only in the green-light transmission area through which green light is transmitted, and is not in the light blocking area and the red- and blue-light transmission areas.

The green color filter 230G may overlap with some of the light blocking areas of the color filter.

By overlapping FIG. 46, element (A), FIG. 46, element (B), and FIG. 46, element (C), a planar structure as shown in FIG. 47 can be obtained.

FIG. 47 is a plan view of a portion of a display panel according to an embodiment.

FIG. 47 is a plan view corresponding to FIG. 7. Unlike the embodiment of FIG. 7, a light blocking area is formed by overlapping two or more color filters instead of a light blocking layer, and the green color filter 230G has an island-shaped structure.

Here, the boundary of the green color filter 230G is further shown outside the second opening OPCFg of the green color filter among the second openings of the color filter, so that the green color filter 230G has an island-shaped structure, and the green color filter 230G, it is clearly shown that the boundary partially overlaps the light blocking area of the color filter.

In FIG. 47, the red color filter 230R and the blue color filter 230B are each located in a light blocking area, but hatches corresponding to the red color filter 230R and the blue color filter 230B are not shown in the light blocking area. Instead, "230B/230R" clearly indicates that the light blocking area is where the blue color filter 230B and the red color filter 230R are located.

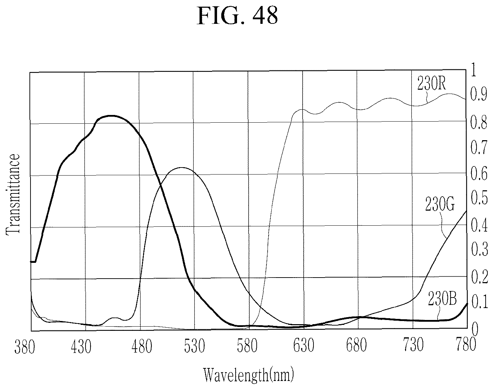

Below, examination of FIG. 48 will determine whether two color filters can be stacked to replace the role of a light blocking layer.

FIG. 48 is a graph showing the transmittance according to the wavelength of the color filter.

In FIG. 48, it is a graph of the transmittance for the wavelengths of each color filter 230R, 230G, 230B, so light in the wavelength range indicated at a high point is transmitted.

Referring to FIG. 48, each color filter 230R, 230G, 230B has a transmittance rate of less than 10% for parts other than the wavelength band that passes through it, and when three or two color filters overlap, it can be confirmed that the wavelength band that passes through is substantially non-existent.

Therefore, it can be confirmed that by overlapping at least two color filters, they can replace the role of the light blocking layer, whether by overlapping three color filters as in FIG. 44, or by overlapping two color filters as in FIG. 45 to FIG. 47.

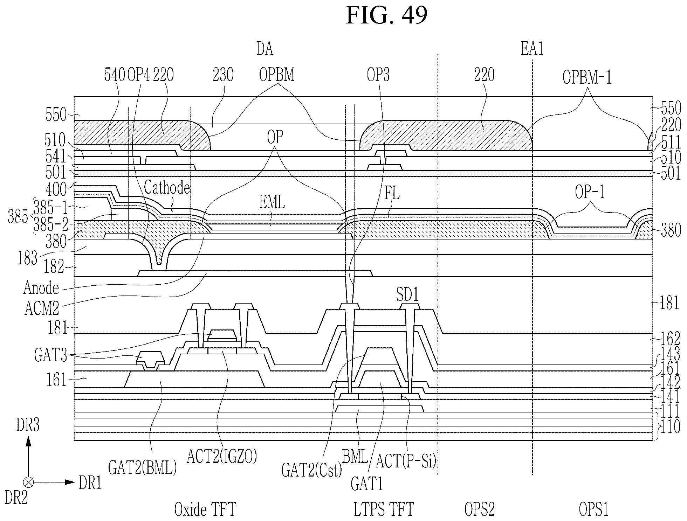

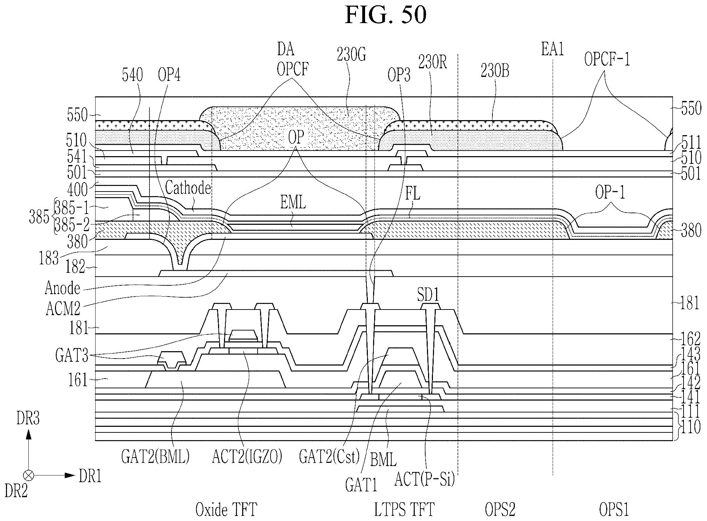

The stacked structure of the display area DA and the first component area EA1 will be examined in more detail through FIG. 49 and FIG. 50.

FIG. 49 and FIG. 50 are cross-sectional views of a light emitting display device according to an embodiment.

FIG. 49 shows an embodiment including a light blocking layer 220, and FIG. 50 shows an embodiment in which a light blocking area of the color filter is formed by overlapping a blue color filter 230B and a red color filter 230R instead of the light blocking layer 220.

First, the embodiment of FIG. 49 will be examined in detail.

A light emitting display device can be largely divided into a lower panel layer and an upper panel layer, the lower panel layer is where the light emitting diodes and pixel circuitry that make up the pixel are located, and may even include an encapsulation layer 400 that covers it.

Here, the pixel circuit part includes the second organic layer 182 and the third organic layer 183, which means the structure underneath, and the light emitting diode is on top of the third organic layer 183, which can mean the structure located underneath the encapsulation layer 400.

The structure located on top of the encapsulation layer 400 may correspond to the upper panel layer.

Referring to FIG. 49, a metal layer BML is located on the substrate 110.

The substrate 110 may include a material that has rigid properties and does not bend, such as glass, or may include a flexible material that can bend, such as plastic or polyimide.

In the case of a flexible substrate, as shown in FIG. 49, it may have a double-layer structure of polyimide and a barrier layer formed of an inorganic insulating material thereon.

The metal layer BML may be in a position that overlaps the channel of the driving transistor in a plan view among the subsequent first semiconductor layers, and is also called a lower shielding layer.

The metal layer BML may include a metal or metal alloy such as copper (Cu), molybdenum (Mo), aluminium (Al), or titanium (Ti).

A buffer layer 111 covering the substrate 110 and the metal layer BML is located on the substrate 110.

The buffer layer 111 serves to block the penetration of impure elements into a first semiconductor layer ACT(P-Si), and may be an inorganic insulating layer including silicon oxide (SiOx), silicon nitride (SiNx), or silicon oxynitride (SiONx), etc.

The first semiconductor layer ACT(P-Si) formed of a silicon semiconductor (e.g., polycrystalline semiconductor (P-Si)) is located on the buffer layer 111.

The first semiconductor layer ACT(P-Si) includes a channel of a polycrystalline transistor LTPS TFT including the driving transistor T1, and a first region and a second region located on both sides thereof.

Here, the polycrystalline transistor LTPS TFT may include not only the driving transistor T1 but also various switching transistors or compensation transistors.

Additionally, the first semiconductor layer ACT(P-Si) has regions on both sides of the channel that have conductive layer characteristics through plasma treatment or doping, and can serve as the first and second electrodes of the transistor.

A first gate insulating layer 141 may be positioned on the first semiconductor layer ACT(P-Si).

The first gate insulating layer 141 may be an inorganic insulating layer containing silicon oxide (SiOx), silicon nitride (SiNx), or silicon oxynitride (SiONx).

A first gate conductive layer including the gate electrode GAT1 of the polycrystalline transistor LTPS TFT may be positioned on the first gate insulating layer 141.

The first gate conductive layer may be formed with a first scan line or an emission control line in addition to the gate electrode of the polycrystalline transistor LTPS TFT.

The first gate conductive layer may include a metal or metal alloy such as copper (Cu), molybdenum (Mo), aluminium (Al), or titanium (Ti), and may include a single layer or multiple layers.

After forming the first gate conductive layer, a plasma treatment or doping process may be performed to make the exposed area of the first semiconductor layer conductive.

The first semiconductor layer ACT(P-Si) obscured by the first gate conductive layer is not conductive, and the part of the first semiconductor layer ACT(P-Si) that is not covered by the first gate conductive layer can have the same characteristics as the conductive layer.

A second gate insulating layer 142 may be positioned on the first gate conductive layer and the first gate insulating layer 141.

The second gate insulating layer 142 may be an inorganic insulating layer containing silicon oxide (SiOx), silicon nitride (SiNx), or silicon oxynitride (SiONx).

A second gate conductive layer including one electrode GAT2(Cst) of the storage capacitor Cst and a lower shielding layer GAT2(BML) of the oxide transistor oxide TFT will be located on the second gate insulating layer 142.

The lower shielding layer GAT2(BML) of the oxide transistor oxide TFT is located at the bottom of the channel of each oxide transistor oxide TFT and serves as a shield from light or electromagnetic interference provided to the channel from the bottom.

One electrode GAT2(Cst) of the storage capacitor Cst overlaps the gate electrode GAT1 of the driving transistor T1 to form the storage capacitor Cst.

Depending on the embodiment, the second gate conductive layer may further include a scan line, a control line, or a voltage line.

The second gate conductive layer may include a metal or metal alloy such as copper (Cu), molybdenum (Mo), aluminium (Al), or titanium (Ti), and may include a single layer or multiple layers.

A first interlayer insulating layer 161 may be positioned on the second gate conductive layer.

The first interlayer insulating layer 161 may include an inorganic insulating layer containing silicon oxide (SiOx), silicon nitride (SiNx), or silicon oxynitride (SiONx), and depending on the embodiment, the inorganic insulating material may be formed thickly.

An oxide semiconductor layer ACT2 (IGZO) including a channel, first region, and second region of the oxide transistor oxide TFT may be located on the first interlayer insulating layer 161.

A third gate insulating layer 143 may be located on the oxide semiconductor layer ACT2(IGZO).

The third gate insulating layer 143 may be located on the entire surface of the oxide semiconductor layer ACT2 (IGZO) and the first interlayer insulating layer 161.

The third gate insulating layer 143 may include an inorganic insulating layer containing silicon oxide (SiOx), silicon nitride (SiNx), or silicon oxynitride (SiONx).

A third gate conductive layer including the gate electrode GAT3 of an oxide transistor oxide TFT may be positioned on the third gate insulating layer 143.

The gate electrode of an oxide transistor oxide TFT may overlap the channel.

The third gate conductive layer may further include a scan line or a control line, and may additionally include a connection electrode connected to the lower shielding layer GAT2(BML) of the oxide transistor oxide TFT.

The third gate conductive layer may contain a metal or metal alloy such as copper (Cu), molybdenum (Mo), aluminium (Al), or titanium (Ti), and may include a single layer or multiple layers.

A second interlayer insulating layer 162 may be positioned on the third gate conductive layer.

The second interlayer insulating layer 162 may have a single-layer or multi-layer structure.

The second interlayer insulating layer 162 may include an inorganic insulating material such as silicon nitride (SiNx), silicon oxide (SiOx), or silicon nitride (SiOxNy), and may include an organic material, depending on the embodiment.

A first data conductive layer SD1 is positioned on the second interlayer insulating layer 162 and includes a connection electrode that can be connected to the first and second regions of each of the polycrystalline transistor LTPS TFT and the oxide transistor oxide TFT.

The first data conductive layer SD1 may include a metal or metal alloy such as aluminium (Al), copper (Cu), molybdenum (Mo), titanium (Ti), and may include a single layer or multiple layers.

A first organic layer 181 may be positioned on the first data conductive layer SD1.

The first organic layer 181 may be an organic insulating layer containing an organic material, and the organic material includes polyimide, polyamide, acrylic resin, benzocyclobutene, and/or phenol resin.

A second data conductive layer including an anode connection electrode ACM2 may be positioned on the first organic layer 181.

The second data conductive layer may include a data line or a driving voltage line.

The second data conductive layer SD2 may include a metal or metal alloy such as aluminium (Al), copper (Cu), molybdenum (Mo), or titanium (Ti), and may include a single layer or multiple layers.

Above a second data conductive layer, a second organic layer 182 and a third organic layer 183 are located, and an anode connection opening OP4 is formed in the second organic layer 182 and the third organic layer 183.

The anode connection electrode ACM2 is electrically connected to the anode through the anode connection opening OP4.

The second organic layer 182 and the third organic layer 183 may be organic insulating layers, and may include polyimide, polyamide, acrylic resin, benzocyclobutene, and/or phenol resin.

Depending on the embodiment, the third organic layer 183 may be omitted.

A pixel defining layer 380 may be positioned on the anode, covering at least a portion of the anode and having an opening OP exposing the anode.

The pixel defining layer 380 may be a black pixel defining layer formed of a black organic material to prevent ambient light from being reflected back, and depending on the embodiment, the pixel defining layer 380 may be formed of a transparent organic material.

Therefore, depending on the embodiment, the pixel defining layer 380 may include a negative-type black organic material and a black pigment.

A spacer 385 is located on the pixel defining layer 380.

The spacer 385 may include a first part 385-1 that is in a high and narrow area, and a second part 385-2 that is in a low and wide area.

Unlike the pixel defining layer 380, the spacer 385 may be formed of a transparent organic insulating material.

Depending on the embodiment, the spacer 385 may be formed of a positive-type transparent organic material.

A functional layer FL and a cathode are sequentially disposed on the anode, the spacer 385, and the pixel defining layer 380, and are formed sequentially in the display area DA and the first component area EA1. The functional layer FL and the cathode can be located in all areas.

The light emitting layer EML is located between the functional layers FL, and the light emitting layer EML may be located only within the opening OP of the pixel defining layer 380.

Hereinafter, the functional layer FL and the light emitting layer EML can be combined to refer to the intermediate layer.

The functional layer FL may include at least one of auxiliary layers such as an electron injection layer, an electron transport layer, a hole transport layer, and a hole injection layer, and the hole injection layer and the hole transport layer may be located below the light emitting layer EML layer, and an electron transport layer and an electron injection layer may be located on top of the light emitting layer EML.

An encapsulation layer 400 is located on the cathode.

The encapsulation layer 400 includes at least one inorganic layer and at least one organic layer, and depending on the embodiment, may have a triple-layer structure including a first inorganic encapsulation layer, an organic encapsulation layer, and a second inorganic encapsulation layer.

The encapsulation layer 400 may protect the light emitting layer EML from ambient moisture or oxygen that may enter.

Depending on the embodiment, the encapsulation layer 400 may include a structure in which an inorganic layer and an organic layer are further sequentially stacked.

Sensing insulating layers 501, 510, 511 and a plurality of sensing electrodes 540, 541 are positioned on the encapsulation layer 400 for touch detection.

In the embodiment of FIG. 49, touch can be detected in a capacitive manner using two sensing electrodes 540 and 541.

For example, a first sensing insulating layer 501 is disposed on the encapsulation layer 400, and a plurality of sensing electrodes 540 and 541 are formed thereon.

The plurality of sensing electrodes 540 and 541 may be insulated with the second sensing insulating layer 510 interposed therebetween, and some of them may be electrically connected through an opening located in the second sensing insulating layer 510.

Here, the sensing electrodes 540 and 541 are made of metal or metal alloy such as aluminium (Al), copper (Cu), silver (Ag), gold (Au), molybdenum (Mo), titanium (Ti), and tantalum (Ta), and they may include a single layer or multiple layers.

A third sensing insulating layer 511 is disposed on the sensing electrode 540.

A light blocking layer 220 and color filters 230R, 230G, 230B are positioned on the third sensing insulating layer 511.

The light blocking layer 220 may overlap the sensing electrodes 540 and 541 in a plan view.

The light blocking layer 220 has an opening OPBM, and the second opening OPBM of the light blocking layer 220 overlaps the opening OP of the pixel defining layer 380 in a plan view.

Additionally, the second opening OPBM of the light blocking layer 220 may be formed wider than the opening OP of the pixel defining layer 380.

As a result, the anode, which is overlapped (i.e., exposed by the opening OP of the pixel defining layer 380), can also have a structure that is not obscured in a plan view by the light blocking layer 220.

This is to ensure that the anode and the light emitting layer EML capable of displaying an image are not obscured by the light blocking layer 220 and the sensing electrodes 540 and 541.

In addition, the light blocking layer 220 has a structure that overlaps the anode connection opening OP4 in a plan view but does not overlap the opening OP3 of the first organic layer 181 in a plan view.

Color filters 230R, 230G, 230B are positioned on the sensing insulating layers 501, 510, and 511, and the light blocking layer 220.

Depending on the embodiment, the color filters 230R, 230G, 230B may be replaced with a color conversion layer or may further include a color conversion layer.

The color conversion layer may include quantum dots.

A planarization layer 550 may be positioned on the color filters 230R, 230G, 230B to cover the color filters 230R, 230G, 230B. Depending on the embodiment, the planarization layer 550 may increase front visibility and light output efficiency of the display device, and a low refractive layer and an additional planarization layer may further be located on top of the planarization layer 550.

Light can be refracted and emitted toward the front by an additional flattening layer with a low refractive layer and a high refractive characteristic.

In this case, depending on the embodiment, the planarization layer 550 may be omitted and a low refractive layer and an additional planarization layer may be located directly on the color filter 230.

In this embodiment, a polarizer is not included on top of the planarization layer 550.

The polarizer can play a role in preventing display quality from deteriorating when external light is incident and reflected by an anode, etc., and is visible to the user.

However, in this embodiment, the side of the anode is covered by the pixel defining layer 380 to reduce the degree of reflection from the anode, and a light blocking layer 220 is also formed to reduce the degree of incident light, thereby reducing the amount of light incident on the anode, and it already contains a structure that prevents deterioration of display quality.

Therefore, there is no need to separately form the polarizer on the front of the display panel DP.

In addition to the stacked structure of the display area DA, FIG. 49 shows the cross-sectional structure of the first component area EA1, which is formed to allow light to penetrate a part of the display area DA.

In FIG. 49, the first component area EA1 is divided into a first optical sensor area OPS1 (also referred to as a transmissive optical sensor area) and a second optical sensor area OPS2 (also referred to as a non-transmissive optical sensor area).

Here, the first optical sensor area OPS1 is an area formed so that light can penetrate, where additional openings OP-1, OPBM-1 are located so as not to overlap with the pixel defining layer 380 and the light blocking layer 220 on a flat plane.

In contrast, the second optical sensor area OPS2 is an area formed to overlap the pixel defining layer 380 and the light blocking layer 220 in a plan view so that light is not transmitted therethrough.

Both the first optical sensor area OPS1 and the second optical sensor area OPS2 of the first component area EA1 might not include a layer that blocks light, such as a metal layer or a semiconductor layer.

For reference, the first optical element ES1 (refer to FIG. 2) is located on the back of the first component area EA1, and the front of the light emitting display device can be detected through the first optical sensor area OPS1 located in the first component area EA1.

For example, the layered structure of the first component area EA1 is as follows.

A buffer layer 111, which is an inorganic insulating layer, is positioned on the substrate 110, and a first gate insulating layer 141 and a second gate insulating layer 142, which are inorganic insulating layers, are sequentially positioned thereon.

Additionally, a first interlayer insulating layer 161, a third gate insulating layer 143, and a second interlayer insulating layer 162, which are inorganic insulating layers, are sequentially stacked on the second gate insulating layer 142.

On the second interlayer insulating layer 162, a first organic layer 181, a second organic layer 182, and a third organic layer 183, which are organic insulating layers, are sequentially stacked.

A functional layer FL may be located on the third organic layer 183, and a cathode may be located on the functional layer FL.

An encapsulation layer 400 is positioned on the cathode, and sensing insulating layers 501, 510, and 511 are sequentially positioned on top of the cathode.

The encapsulation layer 400 may have a triple-layer structure sequentially including an inorganic encapsulation layer, an organic encapsulation layer, and an inorganic encapsulation layer.

Additionally, the sensing insulating layers 501, 510, and 511 may all be inorganic insulating layers.

A planarization layer 550 may be positioned on the sensing insulating layers 501, 510, and 511.

A metal layer, a first semiconductor layer, a first gate conductive layer, a second gate conductive layer, an oxide semiconductor layer, a third gate conductive layer, a first data conductive layer, and a second data conductive layer, and the anode are not located in the first component area EA1 as described above.

Additionally, the light emitting layer EML and the sensing electrodes 540 and 541 are not formed.

Additionally, in the first optical sensor area OPS1 of the first component area EA1, additional openings OP-1, OPBM-1 are formed in the pixel defining layer 380 and the light blocking layer 220, respectively, so that the pixel defining layer 380 and the light blocking layer 220 are not formed.

As a result, light may pass through the first optical sensor area OPS1.

On the other hand, within the first component area EA1, the second optical sensor area OPS2 might have no additional openings OP-1, OPBM-1 present, allowing it to have a structure in which light is not transmitted by overlapping the pixel defining layer 380 and the light blocking layer 220.

In the above, an embodiment was examined in which a total of three organic layers are formed, and an anode connection opening is formed in the second organic layer and the third organic layer.

However, at least two organic layers may be formed, and in this case, the anode connection opening may be located in the upper organic layer located away from the substrate, and the lower organic layer opening may be located in the lower organic layer.

Below, with reference to FIG. 50, an embodiment in which a light blocking area of the color filter is formed by overlapping the blue color filter 230B and the red color filter 230R instead of the light blocking layer 220 will be described.

In FIG. 50, the third sensing insulating layer 511 and the structure below it is the same as the structure in FIG. 49, so only the upper structure of the third sensing insulating layer 511, which is different from FIG. 49, is examined in detail as follows.

Color filters 230R, 230G, 230B are located on the third sensing insulating layer 511.

In the embodiment of FIG. 50, there is no inclusion of a light blocking layer. Instead, the role of the light blocking layer is performed by the overlapped color filters 230R, 230B, which can overlap the sensing electrodes 540, 541 in a plan view.

The overlapped color filters 230R, 230B have a second opening OPCF, and the second opening OPCF of the overlapped color filters 230R, 230B overlaps the opening OP of the pixel defining layer 380 in a plan view.

Additionally, the second opening OPCF of the overlapped color filters 230R, 230B may be wider than the opening OP of the pixel defining layer 380.

As a result, the anode that overlaps the opening OP of the pixel defining layer 380 (i.e., exposed by the opening OP of the pixel defining layer 380) also overlaps the color filters 230R, 230B, so it is possible to have a structure that is not obscured, in a plan view.

This is to ensure that the anode and the light emitting layer EML capable of displaying an image are not obscured by the overlapped color filters 230R, 230B and the sensing electrodes 540 and 541.

Additionally, the overlapped color filters 230R, 230B have a structure that overlaps the anode connection opening OP4 in a plan view.

One color filter may be located within the second opening OPCF of the overlapped color filters 230R, 230B, and in FIG. 50, a green color filter 230G is located there.

Depending on the embodiment, the color filters 230R, 230G, 230B may be replaced with a color conversion layer or may further include a color conversion layer.

The color conversion layer may include quantum dots.

A planarization layer 550 covering the color filters 230R, 230G, 230B is positioned on the color filters 230R, 230G, 230B, and low refractive layers and planarization layers may further be located on top of the planarization layer 550 to increase front visibility and light emission efficiency of the display device.

Depending on the embodiment, the planarization layer 550 may be omitted and a low refractive layer and an additional planarization layer may be located directly on the color filter.

In the embodiment of FIG. 50, the polarizer is not included on top of the planarization layer 550.

The polarizer can play a role in preventing display quality from deteriorating when external light is incident and reflected by an anode, etc., and is visible to the user.

However, in this embodiment, the side of the anode is covered with the pixel defining layer 380 to reduce the degree of reflection from the anode, and overlapping color filters 230R, 230B are also formed to reduce the degree of incident light. In short, it prevents deterioration of display quality due to reflection.

Therefore, there is no need to separately form the polarizer on the front of the display panel DP.

The cross-sectional structure of the first component area EA1 according to the embodiment of FIG. 50 may be as follows.

The first component area EA1 is divided into a first optical sensor area OPS1 and a second optical sensor area OPS2.

Here, the first optical sensor area OPS1 has additional openings OP-1, OPCF-1 located such that they do not overlap in a plan view the light blocking area of the color filter formed by overlapping the pixel defining layer 380 and at least two color filters.

In contrast, the second optical sensor area OPS2 is an area formed to prevent light from being transmitted by overlapping in a plan view the pixel defining layer 380 and the light blocking area of the color filter formed by overlapping at least two color filters.

Both the first optical sensor area OPS1 and the second optical sensor area OPS2 of the first component area EA1 might not include a layer that blocks light, such as a metal layer or a semiconductor layer.

For reference, the first optical element ES1 (refer to FIG. 2) is located on the back side of the first component area EA1, and the front of the light emitting display device can be detected through the first optical sensor area OPS1 located in the first component area EA1.

For example, the layered structure of the first component area EA1 is as follows.

A buffer layer 111, which is an inorganic insulating layer, is positioned on the substrate 110, and a first gate insulating layer 141 and a second gate insulating layer 142, which are inorganic insulating layers, are sequentially positioned thereon.

Additionally, a first interlayer insulating layer 161, a third gate insulating layer 143, and a second interlayer insulating layer 162, which are inorganic insulating layers, are sequentially stacked on the second gate insulating layer 142.

On the second interlayer insulating layer 162, a first organic layer 181, a second organic layer 182, and a third organic layer 183, which are organic insulating layers, are sequentially stacked.

A functional layer FL may be located on the third organic layer 183, and a cathode may be located on the functional layer FL.

An encapsulation layer 400 is positioned on the cathode, and sensing insulating layers 501, 510, and 511 are sequentially positioned on top of the cathode.

The encapsulation layer 400 may have a triple-layer structure sequentially including an inorganic encapsulation layer, an organic encapsulation layer, and an inorganic encapsulation layer.

Additionally, the sensing insulating layers 501, 510, and 511 may all be inorganic insulating layers.

A planarization layer 550 may be positioned on the sensing insulating layers 501, 510, and 511.

The first component area EA1 as described above does not contain a metal layer, a first semiconductor layer, a first gate conductive layer, a second gate conductive layer, an oxide semiconductor layer, a third gate conductive layer, a first data conductive layer, and a second data conductive layer, or an anode.

Additionally, the light emitting layer EML and the sensing electrodes 540 and 541 are not formed.

Additionally, in the first optical sensor area OPS1 of the first component area EA1, additional openings OP-1, OPCF-1 are formed in the pixel defining layer 380 and the light blocking area of the color filter, respectively, which may result in the non-formation of the pixel defining layer 380 and a color filter.

As a result, light may pass through the first optical sensor area OPS1.

On the other hand, the second optical sensor area OPS2 of the first component area EA1 does not have additional openings OP-1, OPCF-1 and overlaps the light blocking area of the pixel defining layer 380 and the color filter to transmit light may have a structure that is not transparent.

In the above, examination was done of an embodiment in which a total of three organic layers are formed, and an anode connection opening is formed in the second organic layer and the third organic layer.

However, at least two organic layers may be formed, and in this case, the anode connection opening may be located in the upper organic layer located away from the substrate, and the lower organic layer opening may be located in the lower organic layer.

Additionally, it may be possible to make variations as shown in Table 3 below if the opening OP of the pixel defining layer 380 described above, the second opening OPBM of the light blocking layer 220, and the second opening OPCF of the light blocking area where two or more color filters are overlapped have an elliptical or similar structure.

**[Table 3]**

| Item | Transformable content | |
|---|---|---|
| Ellipse angle | The major axis angle includes four or more directions. | |
| | The angle formed by the major axis direction of each elliptical shape can be less than 45 degrees. The angle formed by the major axis of each ellipse can have different angles for each ellipse. | |
| Eccentricity | (1) It can have an eccentricity between 0.2 and 0.85. | |
| Elliptical shape | | It can have a flat shape formed by cutting in the first direction and then combining. |
| | Also, according to the embodiment, two ellipses with different eccentricities can be combined for each color, and even if it is the same color, two ellipses with different eccentricities can be combined to form various ellipses. | |
| | (3) It is also possible to have a shape composed of two or more ellipses with different eccentricities. | |
| Elliptical arrangement area | (1) The red, green, and blue openings for the pixel definition mask can each be formed as an ellipse with at least two different eccentricities. | |
| | Also, the red second opening, green second opening, and the blue second opening of the light blocking layer or color filter's light blocking area can each be formed as an ellipse with at least two different eccentricities. | |
| First opening and second opening relationship | First opening and a second opening that overlaps with it in a plan view can be formed at regular intervals in a plan view. | |
| | The first opening and the second opening, which overlap with it in a plan view, can have a horizontal distance of 0 µm to 20 µm. | |
| | The first opening and the second opening that overlap with it in a plan view can each have a major axis direction of an elliptical shape that is either the same or has an angle of 20 degrees or less. | |
| | It can have elliptical shapes with different eccentricities for the same color as well. | |
| | Among the five three-color openings, in addition to red, one more color can have a shape with irregular horizontal spacing. | |

Although the embodiments have been described in detail above, the scope of the present invention is not necessarily limited thereto, and various modifications can be made by those skilled in the art using the basic concepts of the present disclosure.

## Claims

1. A light emitting display device, comprising:
a substrate,
a plurality of anodes disposed on the substrate,
a pixel defining layer having a plurality of first openings overlapping each of the plurality of anodes,
a plurality of light emitting layers, each disposed within the plurality of first openings of the pixel defining layer,
a cathode disposed on both the plurality of light emitting layers and the pixel defining layer,
an encapsulation layer disposed on the cathode, and
a light blocking layer disposed on the encapsulation layer and including a plurality of second openings, each overlapping the plurality of first openings, respectively, and
one unit pixel includes four light emitting areas,
wherein the four light emitting areas include two light emitting areas of a first color, one light emitting area of a second color, and one light emitting area of a third color,
wherein the light emitting areas of the first color have a diamond shape, and the light emitting areas of the second color and the third color each have a rectangular shape, and
wherein at least one first opening, among the plurality of first openings of the pixel defining layer, or at least one second opening, among the plurality of second openings of the light blocking layer, has an oval shape.

2. The light emitting display device of claim 1, wherein:
the oval shape includes four or more major axis angles, and
an angle formed by the major axis of the oval shape is 45 degrees or less.

3. The light emitting display device of claim 1 or claim 2, wherein:
the oval shape is a light emitting display device having an eccentricity within a range of from 0.2 to 0.85.

4. The light emitting display device of any one of claims 1 to 3, wherein:
the first opening and the second opening that overlaps the first opening have a horizontal gap within a range of greater than 0 µm to 20 µm.

5. The light emitting display device of any one of claims 1 to 4, wherein:
the elliptical shape is a light emitting display device having a flat shape that merges at least two elliptical shapes with different plane eccentricities.

6. The light emitting display device of claim 5, wherein:
the elliptical shape is a light emitting display device having a planar shape formed by cutting a first ellipse having a first eccentricity and a second ellipse having a second eccentricity in a first direction and then combining them.

7. The light emitting display device of any one of claims 1 to 6, wherein:
both the first opening of the pixel defining layer and the second opening of the light blocking layer each have an oval shape.

8. The light emitting display device of any one of claims 1 to 6, wherein:
one of the first opening of the pixel defining layer and the second opening of the light blocking layer has a circular shape, and the other has an oval shape, optionally wherein:
the first opening has a circular shape, and the second opening has an oval shape, and
the first opening and the second opening are in contact with each other.

9. The light emitting display device of any one of claims 1 to 8, further comprising:
a plurality of color filters that respectively fill the plurality of second openings.

10. A light emitting display device, comprising:
a substrate,
a plurality of anodes disposed on the substrate,
a pixel defining layer having a plurality of first openings overlapping each of the plurality of anodes,
a plurality of light emitting layers each disposed within the plurality of first openings of the pixel defining layer,
a cathode disposed on both the plurality of light emitting layers and the pixel defining layer,
an encapsulation layer disposed on the cathode, and
a plurality of color filters corresponding to different colors disposed on the encapsulation layer,
wherein the plurality of color filters include a plurality of second openings in which at least two color filters of the plurality of color filters are overlapped in a light blocking area of the color filter, and only one color filter of the plurality of color filters is disposed,
wherein one unit pixel includes four light emitting areas,
wherein the four light emitting areas include two light emitting areas of a first color among the three-color light emitting areas, one light emitting area of a second color, and one light emitting area of a third color,
wherein the light emitting area of the first color has a diamond shape, and the light emitting areas of the second color and the third color each have a rectangular shape, and
wherein at least one first opening among the plurality of first openings of the pixel defining layer or at least one second opening among the plurality of second openings of the color filter has an oval shape.

11. The light emitting display device of claim 10, wherein:
(i) the oval shape includes four or more major axis angles, and
an angle formed by the major axis of the oval shape is 45 degrees or less; and/or
(ii) the oval shape is a light emitting display device having an eccentricity within a range of 0.2 to 0.85; and/or
(iii) the first opening and the second opening that overlaps the first opening have a horizontal gap within a range of more than 0 µm to 20 µm.

12. The light emitting display device of claim 10 or claim 11, wherein:
the elliptical shape is a light emitting display device having a flat shape that merges at least two elliptical shapes with different plane eccentricities, optionally wherein:
the elliptical shape is a light emitting display device having a planar shape formed by cutting a first ellipse having a first eccentricity and a second ellipse having a second eccentricity in a first direction and then combining them.

13. The light emitting display device of any one of claims 10 to 12, wherein:
in the light blocking area of the color filter, a blue color filter and a red color filter overlap, and
each of the plurality of second openings overlaps one of a blue color filter, a red color filter, and a green color filter.

14. The light emitting display device of any one of claims 10 to 13, wherein:
the first opening of the pixel defining layer and the second opening of the color filter both have an oval shape.

15. The light emitting display device of any one of claims 10 to 13, wherein:
one of the first opening of the pixel defining layer and the second opening of the color filter has a circular shape, and the other has an oval shape, optionally wherein:
the first opening has a circular shape, and the second opening has an oval shape, and
the first opening and the second opening are in contact with each other.
